# EUROPEAN PATENT SPECIFICATION

(11) **EP 3 932 810 B1**
(45) Date of publication and mention of the grant of the patent: **01.05.2024**
(21) Application number: 19908082.1
(22) Date of filing: 21.06.2019
(51) Int. Cl.: G06Q 10/063, G06N 5/045, B64G 1/64, B64G 1/24, G06Q 50/30, G06Q 10/06

(54) **FLIGHT CONTROL INTELLIGENT DATA ANALYSIS AND DECISION SUPPORT SYSTEM FOR SPACECRAFT RENDEZVOUS AND DOCKING**
SYSTEM ZUR INTELLIGENTEN DATENANALYSE UND ENTSCHEIDUNGSUNTERSTÜTZUNG BEI DER FLUGSTEUERUNG FÜR RENDEZVOUS UND ANDOCKEN VON RAUMFAHRZEUGEN
SYSTÈME INTELLIGENT D'AIDE À LA DÉCISION ET D'ANALYSE DE DONNÉES DE COMMANDE DE VOL POUR RENDEZ-VOUS ET AMARRAGE DE VÉHICULE SPATIAL

(30) Priority: 26.02.2019 CN 201910140961
(43) Date of publication of application: 05.01.2022
(73) Proprietor: Beijing Institute of Control Engineering, Beijing 100086 (CN)
(72) Inventor: XIE, YONGCHUN, Beijing 100086 (CN); CHEN, ZHAOHUI, Beijing 100086 (CN); WANG, ZHENHUA, Beijing 100086 (CN); YUAN, LI, Beijing 100086 (CN); ZHANG, DUZHOU, Beijing 100086 (CN); YANG, BAOHUA, Beijing 100086 (CN); YANG, MENGFEI, Beijing 100086 (CN); HU, JUN, Beijing 100086 (CN); ZHANG, QIANG, Beijing 100086 (CN); LUO, GUQING, Beijing 100086 (CN); ZHANG, GUOFENG, Beijing 100086 (CN); ZHANG, HAO, Beijing 100086 (CN); LI, XIAOFENG, Beijing 100086 (CN); CHEN, CHANGQING, Beijing 100086 (CN); JIANG, YUNSONG, Beijing 100086 (CN); WU, HAO, Beijing 100086 (CN)
(74) Representative: Potter Clarkson
(86) International application number: PCT/CN2019/092211
(87) International publication number: WO 2020/173020

(56) References cited:
- CN-A- 104 061 926
- CN-A- 104 486 335
- CN-A- 105 109 711
- CN-A- 109 189 089
- CN-B- 104 486 335
- CN-B- 105 109 711
- RU-C1- 2 669 330
- YULEI HU: "The Research of Commanding and Displaying System in the Measuring and Controlling Assignment of Spaceflight", CHINESE MASTER’S THESES FULL-TEXT DATABASE, ENGINEERING SCIENCE AND TECHNOLOGY II, 15 April 2014 (2014-04-15), pages 1-69, XP055729872,
- Yulei Hu: "The Research of Commanding and Displaying System in the Measuring and Controlling Assignment of Spaceflight", Chinese Master s Theses Full-Text Database, Engineering Science and Technology II, 15 April 2014 (2014-04-15), pages 1-58, XP055729872,

## Description

The present application claims priority to Chinese Patent Application No. 201910140961.5, titled "SYSTEM FOR INTELLIGENT DATA ANALYSIS AND DECISION SUPPORT IN FLIGHT CONTROL FOR SPACECRAFT RENDEZVOUS AND DOCKING", filed on February 26, 2019 with the China National Intellectual Property Administration.

### FIELD

The present disclosure relates to the technical field of ground flight control and support for spacecraft, and in particular, to a system for intelligent data analysis and decision support in spacecraft rendezvous and docking flight control.

### BACKGROUND

Spacecraft engineering is a system engineering of high risks, high costs and high complexity. Spacecraft flight control is an important part of aerospace engineering. Space rendezvous and docking is a difficult and important mission in the spacecraft flight control. During space rendezvous and docking of spacecraft, two or more spacecraft implement rendezvous and docking in a space orbit, and a relative velocity and a trajectory are controlled to be within a certain safety range. Safety in the rendezvous is affected by correct operation of a relative navigation sensor and an actuator. In such process, it is necessary that the flight control is accurate and a fault is timely and effectively addressed, which is a key step to implement complex space missions such as establishing a space station on an orbit, sampling and returning of space objects, and manned=space exploration. Space rendezvous and docking is widely used in the aerospace field, and is a key step to implement complex space missions such as establishment of a space station, regular rotation of astronauts, transportation of a space shuttle, sampling and returning of a space object, manned moon landing, manned Mars landing, and spacecraft on-orbit service.

In guidance for the rendezvous and docking, fuel consumption and rendezvous time are considered as constraints, so as to plan a reasonable trajectory for rendezvous and determine a velocity increment in orbit transfer for achieving such trajectory. In navigation for the rendezvous and docking, parameters of translation and rotation that are required for guidance and control are pre-estimated through a designed filtering algorithm, based on information from a measurement sensor and a motion model of a spacecraft. Control information for the rendezvous and docking includes a control force and a control moment applied on the spacecraft (usually a tracker), which are calculated through a certain algorithm based on navigation information in accordance with a requirement of guidance and attitude control. An actuator, such as an engine, is applied to implement control based on the docking control information. An ultimate goal of the guidance, navigation and control for the rendezvous and docking is as follows. A position, a velocity, an attitude angle, and an attitude angular velocity of a tracker relative to a target are controlled before docking mechanisms of the two spacecraft contact with each other, such that conditions for docking the two mechanisms are satisfied.

The amount of data to be monitored in rendezvous and docking in flight control is growing, and decisions concerning flight control are increasingly dependent on interpreting and comparing the real-time data in the flight control and the data of simulation and verification. Missions of spacecraft on-orbit flight control is increasingly complex. Although autonomous flight capabilities as well as a level of automation and intelligence are greatly improved for the spacecraft, ground personnel are still necessary to participate in executing various major flight events. Particularly, rendezvous and docking involve coordinated control of multiple spacecraft, and thereby puts high requirements on safety and timeliness. In such case, it still depends mainly on the ground personnel for decision and intervention in strategies all over the world.

Generally, an auxiliary support method is used to assist decision making during a mission of spacecraft flight control, so as to improve accuracy. At present, a conventional method may include the following measures: real-time monitoring of telemetry data in flight control, mathematical simulation and calculation of solutions, target-machine accompanying verification, and the like. For example, the European Space Agency (ESA) widely uses EuroSim, which is a configurable simulator (framework) tool, and the main function of EuroSim is to build a configurable simulator for digital simulation. The control center of Gamma Ray Observer (GRO) develops two tools, namely, the Backup Control Mode Analysis and Utility System (BCAUS) and the Expert System Forecaster (ESP), which are a neural network and an expert system diagnostic tool for determining a cause of mode-fault switching in an on-board control system. The diagnostic process of BCAUS starts by analyzing the development trend of telemetry values. European Space Measurement and Control Center (ESOC) and European Space Research and Technology Center (ESTEC) of ESA define a method under the application background of a mission of scientific satellite ROSETTA for detecting a comet core, and the method applies what is originally developed for a central detection system to a flight control system. Afterwards, such method is also applied to other scientific satellites of ESA, such as the mission of Mars Express. The communication link expert assistance countermeasure system (CLEAR) of Goddard Space Flight Center of NASA is an expert system for diagnosing a fault in a communication link between the cosmic background detector (COBE) and the relay satellite (TDRS). CLEAR is capable of insolating the faults during flight, and performing fault diagnosis and analysis on real-time flight data. A simulation support system EPOCH 2000 developed by Integral Systems, Inc. in the United States is equipped with a trend analysis software EPOCH ABE, which provides an operating function supporting measurement and control in a flight mission.

In the aforementioned measures, simulation, verification, and real-time data analysis are performed separately to solve problems independently. The support system lacks an overall organic connection, and is not capable of comparing simulation data, target-machine verification data and real-time orbit data effectively. Especially, the system lacks the capability of pre-estimation and determination for comprehensive intelligent analysis and comparison based on real-time data, historical data and simulation data. In addition, the current flight control system has a low degree of automation and depends heavily on the ground personnel. Both normal operation and emergency response are maintained by the personnel, which not only increases burden on the personnel but also results in potential delay in emergency response to a sudden failure.

There are several conventional solutions to support flight control. The first technical solution is monitoring real-time telemetry data in the flight control. The state of flight control is determined based on current real-time flight control data in a telemetry downlink. The second technical solution is mathematical simulation and calculation for solutions. Mathematical calculation and simulation are performed with a certain on-orbit operating condition as an initial reference, so as to obtain a result of simulation and calculation for a period of time. The state of a flight control event is evaluated based on the result of simulation and calculation. The third technical solution is target-machine accompanying verification. A target machine is operated, with a certain on-orbit operating condition as an initial reference, to obtain verification data. The verification is usually performed in advance, so as to obtain data of a flight state that is approximate to a real on-orbit flight state. The target-machine verification refers to a semi-physical simulation test system, with a spacecraft computer as a core, which may execute logic via software and simulate real time sequence via software to the most extent. In the mathematical simulation and calculation for solutions and the target-machine accompanying verification, a relevant fault state is further configured and processed, so as to determine a performance of the spacecraft when there is on-orbit abnormity. Patent document with publication No. CN105109711B provides a system for simulating spacecraft rendezvous, in which an indoor GPS unit is used for measuring positions and altitudes and uploading the measurements to a main control module and a monitor in real time. Patent document with publication No. CN104486335B provides an intelligent system for processing GNC data of spacecraft in real time, which uses distributive architecture comprising a CCSDC-based unpacking module and a decoding module. Document "The Research of Commanding and Displaying System in the Measuring and Controlling Assignment of Spaceflight" (Chinese Master's Theses Full-Text Database, Engineering Science and Technology II, 15 April 2014) reviews the developments of the commanding and displaying system, the requirement of the missile pilot shooting range in the future, and the assistant decision-making system in the missile pilot shooting range.

There are some problems in the conventional technical solutions. In the technical solution 1), only the real-time state in the flight control is monitored, and a future event cannot be pre-estimated and forecasted in advance, resulting in a limited support for the decision in the flight control. In the technical solution 2), the mathematical simulation capable of estimating and forecasting a future state is a purely logical operation process. The simulation of time sequence for operation and processing on a real satellite and a real spacecraft computer system is still different from a state in real flight. In the mathematical simulation, it is tedious to set initial conditions that are oriented by an on-orbit state in a real flight mission. Relevant variables are necessary to be extracted manually from a real-time flight control telemetry system, resulting in low efficiency in preparation and slow speed in operation. Thereby, limited support is provided for the decision in the flight control under emergency situations. In the technical solution 3), the target-machine accompanying verification is capable to effectively simulate a forecasted on-orbit state when the verification is performed in advance, and is not capable to timely verify a state caused by a sudden event. Thereby, it is difficult to provide support for the decision effectively.

### SUMMARY

The present disclosure is to address the aforementioned technical issue in conventional technology. A system for intelligent data analysis and decision support in spacecraft rendezvous and docking flight control is provided according to embodiments of the present disclosure, which achieves following effects. During flight control missions such as on-orbit rendezvous and docking of spacecraft, a real-time data variable in the flight control at any moment is fast acquired. Mathematical simulation and target-machine verification in advance are performed, with the real-time data variable as an initial condition. Simulation data is transmitted to a sub-module for fusing multi-source data for comparison with real-time flight control data, so as to verify safety of the flight control mission. The real-time flight control data is monitored, interpreted, analyzed, compared, pre-estimated and forecasted. Current flight state information and pre-estimated future operation state information of the spacecraft are provided to a supervisor of the flight control, such that the supervisor can quickly make accurate determination for an event in the flight control. It is achieved that the real-time flight control data is compared with pre-estimation and forecast data, and the simulation and verification data is compared with history data in flight control decision. It is achieved that an operation state in a normal operating condition is quickly analyzed and compared with an operation state in a fault. Thereby, an important basis is provided for the flight control decision of spacecraft. The system is high in intelligent autonomy, and is timely and effective in response, thereby ensuring safety in the rendezvous and docking.

In order to address the aforementioned technical problems, a system for intelligent data analysis and decision support in spacecraft rendezvous and docking flight control is provided according to an embodiment of the present disclosure. The system includes:
a module for acquiring and processing real-time data in flight control, configured to acquire original telemetry data information from a space-based station and a ground-based station from a flight control center, and extract according to set rules a desired telemetry source packet from multiple time-sequenced data packets from multiple non-homologous stations;
the module for simulation and verification in flight control, configured to: acquire an initial condition for simulation and verification, from a module for fusing and processing multi-source data; perform simulation and verification for a flight control scheme, to obtain simulation and verification data for the flight control scheme; perform simulation and verification for control software, to obtain simulation and verification data for the control software; perform physical verification for a target machine, to obtain verification result data for the target machine; and transmit the simulation and verification data for the flight control scheme, the simulation and verification data for the control software, and the verification result data for the target machine to the module for fusing and processing multi-source data;
the module for fusing and processing multi-source data, configured to automatically parse real-time flight control data, the simulation and verification data for the flight control scheme, the simulation and verification data for the control software, the verification result data for the target machine, and flight data of history rendezvous and docking missions that are transmitted to the module for fusing and processing multi-source data, and store the parsed data in a module for memory-database processing;
the module for memory-database processing, configured to solidify the parsed data to a hard disk at each set time interval, via a hardware interface;
a module for intelligent analysis in flight control, configured to monitor and analyze the real-time flight control data, the simulation and verification data for the flight control scheme, and the simulation and verification data for the control software that are acquired from the module for fusing and processing multi-source data, and pre-estimate and forecast a trajectory curve; and
a module for decision support in flight control, configured to perform a support operation for a flight control decision by interpreting a condition and a state, based on data that are transmitted from the module for acquiring and processing real-time data in flight control, the module for simulation and verification in flight control, and the module for intelligent analysis in flight control, to the module for fusing and processing multi-source data.

The system for intelligent data analysis and decision support in spacecraft rendezvous and docking flight control further includes:
a module for displaying curves and processing interface operations, configured to display multi-source heterogeneous data corresponding to the support operation as a curve, refresh the multi-source heterogeneous data on an interface periodically or for once, to enable the multi-source heterogeneous data to be adjustable along a horizontal axis and a vertical axis, facilitating data comparison and analysis.

In the system for intelligent data analysis and decision support in spacecraft rendezvous and docking flight control, the module for acquiring and processing real-time data in flight control includes:
a sub-module for extracting complex telemetry packets, configured to acquire the original telemetry data information of the space-based station and the ground-based station from the flight control center, and acquire the information of the desired telemetry source packet from the multiple time-sequenced data packets by extracting according to a set rule, where the time-sequenced data packets are from multiple non-homologous stations; and
a sub-module for dynamically selecting stations, configured to perform dynamic selection of a station on the data extracted by the sub-module for extracting complex telemetry packets, based on a strategy of a unified time sequence, and obtain data required for decision support in the flight control through data filtering.

In the system for intelligent data analysis and decision support in spacecraft rendezvous and docking flight control, the module for simulation and verification in flight control includes:
a sub-module for simulation and verification of flight control schemes, configured to: perform simulation and verification for the flight control scheme, with on-orbit data of the flight control obtained from the module for fusing and processing multi-source data as an initial condition, to obtain the simulation and verification data for the flight control scheme; analyze the simulation and verification data for the flight control scheme, or transmit the simulation and verification data for the flight control scheme to the module for fusing and processing multi-source data for comparison with the real-time flight control data, where the simulation and verification for the flight control scheme includes verifying in advance a critical function for safety of the flight control, Monte Carlo experiment and bias test.
a sub-module for simulation and verification of control software, configured to: perform, for a flight mission, quick verification on software of a software simulation platform for the flight control, with the on-orbit data of the flight control obtained from the module for fusing and processing multi-source data as an initial condition, to obtain an operation state of the software under a corresponding condition as the simulation and verification data for the control software; and transmit the simulation and verification data for the control software to the module for fusing and processing multi-source data for comparison with the real-time flight control data; and
a sub-module for target-machine physical verification, configured to: test and verify the flight mission, with the on-orbit data of the flight control obtained from the module for fusing and processing multi-source data as an initial condition, to obtain verification result data for the target machine; and analyze the verification result data for the target machine, or transmit the verification result data for the target machine to the module for fusing and processing multi-source data for comparison with the real-time flight control data.

In the system for intelligent data analysis and decision support in spacecraft rendezvous and docking flight control, the module for fusing and processing multi-source data includes:
a sub-module for fusing multi-source data, configured to: parse automatically the real-time flight control data, the simulation and verification data for the flight control scheme, the simulation and verification data for the control software, the verification result data for the target machine, and the flight data of history rendezvous and docking missions; and store the parsed data in the module for memory-database processing;
a sub-module for data acquisition, configured to read feature information of a predefined configuration file, and acquire independent data of a corresponding variable at a specified moment or acquire an array of data of the corresponding variable within a continuous period;
a sub-module for dynamic setting, configured to generate a new variable required in the flight control mission by operating on an interface or linking to a dynamic library, generate a configuration file based on the new variable required in the flight control mission, and load configuration information in the configuration file dynamically to a storage sequence; and
a sub-module for history flight data, configured to store a typical process and typical state data of the flight control, and provide basic data for comparison in data processing of the module for intelligent analysis in flight control.

In the system for intelligent data analysis and decision support in spacecraft rendezvous and docking flight control, the module for intelligent analysis in flight control includes:
a sub-module for monitoring real-time states, configured to monitor information of a real-time flight state, and obtain real-time data of a key data variable in the flight control, where the real-time data of the key data variable in the flight control includes orbit information, attitude information, sensor state information, sensor measurement information, and actuator data;
a sub-module for interpreting intelligent data, configured to perform intelligent data analysis based on states of simulation data, history data, and real-time flight data, and provide support data for interpretation in the support operation for the flight control decision; and
a sub-module for forecasting flight states, configured to pre-estimate and forecast the trajectory curve, with real-time on-orbit flight data as an initial condition, to obtain a forecast result for a state of the flight control before a key event and provide decision support for determination in advance in a flight control mission.

In the system for intelligent data analysis and decision support in spacecraft rendezvous and docking flight control, the module for intelligent analysis in flight control is further configured to provide a standardized interface, via which an external plugin exchanges data with the module for intelligent analysis in flight control.

In the system for intelligent data analysis and decision support in spacecraft rendezvous and docking flight control, the module for decision support in flight control includes:
a sub-module for automatic decision processing in normal flight control procedure, configured to: extract, based on the flight mission, data required in the flight mission from the module for fusing and processing multi-source data, and generate uplink injection data based on the extracted data required in the flight mission; determine the data required in the flight mission and the uplink injection data as input data, and trigger the module for simulation and verification in flight control to simulate and verify the uplink injection data, to obtain a result of simulation and verification; upload the uplink injection data that is verified to the spacecraft, via the module for fusing and processing multi-source data that acquires the result of simulation and verification outputted by the module for simulation and verification in flight control; and acquire an operating result of the spacecraft, which is based on the uplink injection data that is verified, and verify again, based on the operating result, the uplink injection data that is verified; where the result of simulation and verification that is outputted by the module for simulation and verification in flight control and acquired by the module for fusing and processing multi-source data includes: the uplink injection data that is verified through the simulation and verification; and where the data required in the flight mission includes spacecraft attitude information, orbit information, and health information of an operation state;
a sub-module for safety pre-warning processing, configured to: acquire safety state information of the spacecraft, safety corridor information of an orbit, and health state information of a sensor actuator, from the module for fusing and processing multi-source data; compare the safety state information of the spacecraft, the safety corridor information of the orbit, and the health state information of the sensor actuator with thresholds, respectively; and perform safety pre-warning based on a result of the comparing; and
a sub-module for fault emergency processing, configured to: acquire information of a sudden emergency fault during the flight mission, from the module for fusing and processing multi-source data; select a contingency plan for the sudden emergency fault, where the contingency plan matches the information of the sudden emergency fault; determine whether the sudden emergency fault is eliminated after executing the sudden emergency fault contingency plan; and trigger the sub-module for safety pre-warning processing, in a case that the sudden emergency fault is eliminated.

In the system for intelligent data analysis and decision support in spacecraft rendezvous and docking flight control, the module for displaying curves and processing interface operations includes:
a sub-module for display curves, configured to refresh, periodically or for once, the multi-source heterogeneous data corresponding to the support operation for the flight control decision on the interface, to enable the multi-source heterogeneous data to be adjustable along a horizontal axis and a vertical axis, facilitating data comparison and analysis and providing a scene of visual display for data processing; and
a sub-module for interface operations, configured to provide a function option for managing a configuration file, a function option for storing data, a function option for extracting data, a function option for displaying a curve, a function option for data calculation, and a function option for linking to a dynamic processing library.

The following advantages are achieved according to embodiments of the present disclosure.
(1) Solutions and approaches for intelligent data analysis and decision support in the flight control are completely provided for missions of spacecraft rendezvous and docking. A routine process in the flight control can be autonomously managed, and an alarm for a potential abnormal state can be reported in time, facilitating operations of the ground personnel. A response to a major sudden emergency can be made quickly and timely, when it is authorized in a task. Thereby, it ensures that the spacecraft operates safely while waiting for subsequent actions.
(2) The real-time data, the simulation calculation, and the target-machine verification data of a flight mission are stored in a complete, efficient and expansible manner for the flight control mission. On such basis, data of a variable of interest (including history data at any moment and real-time data) can be acquired quickly and accurately. This solves the problem in a conventional flight control environment, that is, mathematical simulation calculation and target-machine verification cannot be quickly performed based on orbit data at a certain moment since acquisition of data is tedious and slow. A period for acquiring data of a specified variable at any moment is reduced from more than 3 minutes to 2 seconds on average, thereby improving the performance by nearly 100 times.
(3) Multi-source heterogeneous data, such as the real-time on-orbit data, the data of simulation and comparison, and the target-machine verification data, can be efficiently fused in the flight control mission for the spacecraft. For the first time, it is achieved that the capability of pre-estimating and forecasting the flight state flexibly, fast, and accurately. Significantly improved are capabilities for comparing and analyzing data that is monitored in real time, and for positioning and analyzing an on-orbit fault quickly.

### BRIEF DESCRIPTION OF THE DRAWINGS

Figure 1 is a structural block diagram of a system for intelligent data analysis and decision support in spacecraft rendezvous and docking flight control according to an embodiment of the present disclosure;
Figure 2 is a schematic diagram of an operation flow of a sub-module for extracting complex telemetry packets according to an embodiment of the present disclosure;
Figure 3 is a schematic diagram of an operation flow of a sub-module for dynamically selecting stations according to an embodiment of the present disclosure;
Figure 4 is a schematic diagram of an operation flow of a sub-module for simulation and verification of flight control schemes according to an embodiment of the present disclosure;
Figure 5 is a schematic diagram of an operation flow of a module for fusing and processing multi-source data according to an embodiment of the present disclosure;
Figure 6 is a schematic diagram of an operation flow of a sub-module for monitoring real-time states according to an embodiment of the present disclosure;
Figure 7 is a schematic diagram of processing in automatic decision for a normal flight control procedure according to an embodiment of the present disclosure;
Figure 8 is a schematic diagram of automatic decision of a normal flight control procedure according to an embodiment of the present disclosure;
Figure 9 is a schematic diagram of data processing in a system for intelligent data analysis and decision support in spacecraft rendezvous and docking flight control according to an embodiment of the present disclosure;
Figure 10 is a schematic diagram of a simple algorithm according to an embodiment of the present disclosure;
Figure 11 is a flowchart of a method for forecasting and processing a trajectory based on on-orbit data fusion according to an embodiment of the present disclosure; and
Figure 12 is a schematic diagram of an output curve as a result of trajectory forecast according to an embodiment of the present disclosure.

### DETAILED DESCRIPTION OF EMBODIMENTS

In order to make objects, technical solutions, and advantages of the present disclosure clearer, hereinafter embodiments of the present disclosure are further described in conjunction with the drawings.

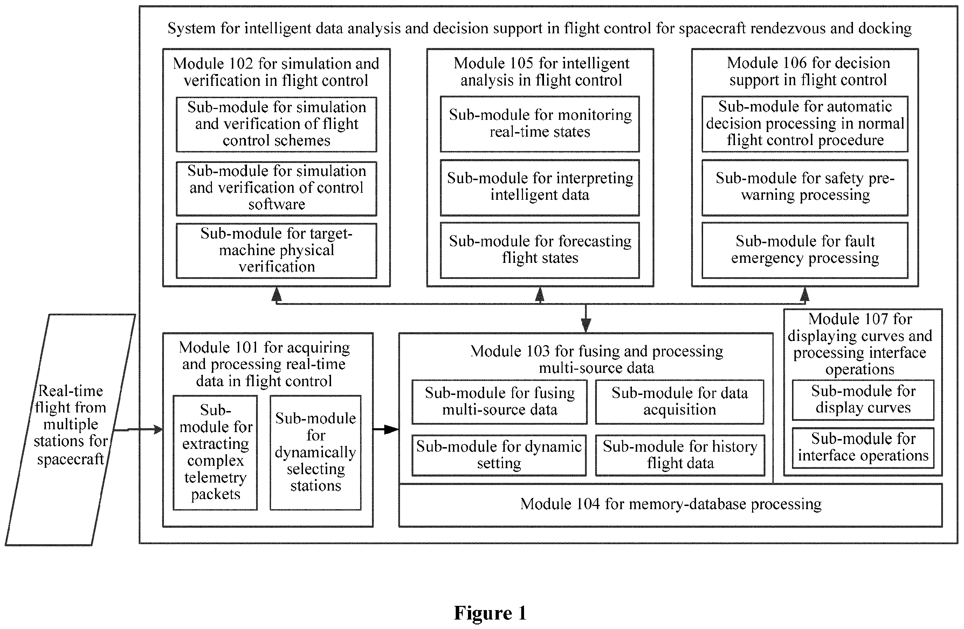

Reference is made to Figure 1, which is a structural block diagram of a system for intelligent data analysis and decision support in spacecraft rendezvous and docking flight control according to an embodiment of the present disclosure. The system for intelligent data analysis and decision support in spacecraft rendezvous and docking flight control includes: a module 101 for acquiring and processing real-time data in flight control, a module 102 for simulation and verification in flight control, a module 103 for fusing and processing multi-source data, a module 104 for memory-database processing, and a module 105 for intelligent analysis in flight control, a module 106 for decision support in flight control.

**The module 101 for acquiring and processing real-time data in flight control** is configured to acquire original telemetry data information of a space-based station and a ground-based station from a flight control center, and acquire information of a desired telemetry source packet from multiple time-sequenced data packets by extracting according to a set rule. The time-sequenced data packets are from multiple non-homologous stations.

In one embodiment, the module 101 for acquiring and processing real-time data in flight control includes a sub-module for extracting complex telemetry packets and a sub-module for dynamically selecting stations. The sub-module for extracting complex telemetry packets is configured to acquire the original telemetry data information of the space-based station and the ground-based station from the flight control center, and acquire the information of the desired telemetry source packet from the multiple time-sequenced data packets by extracting according to a set rule. The time-sequenced data packets are from multiple non-homologous stations. The sub-module for dynamically selecting stations is configured to perform dynamic selection of a station on the data extracted by the sub-module for extracting complex telemetry packets, based on a strategy of a unified time sequence, and obtain data required for decision support in the flight control through data filtering.

### Sub-module for extracting complex telemetry packets

In one embodiment, the sub-module for extracting complex telemetry packets may extract a data transmission feature relevant to the AOS packed telemetry method of the CCSDS (Consultative Committee for Space Data Systems). Information of the relevant feature information is extracted as a configuration file, and content of the feature information defined in the configuration file is read. The CADU packet in telemetry downlink is read to accurately obtain all EPDU packets. A variable in a corresponding EPDU packet is automatically parsed and processed, so as to obtain a value of the telemetry variable.

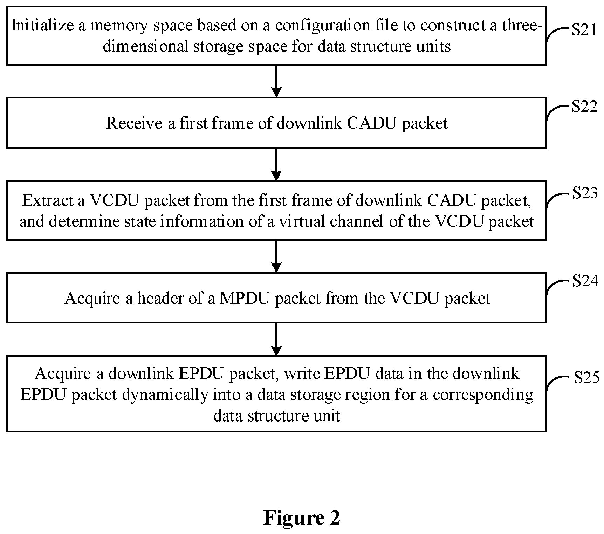

Reference is made to Figure 2, which is a schematic diagram of an operation flow of a sub-module for extracting complex telemetry packets according to an embodiment of the present disclosure. In one embodiment, the operation flow of the sub-module for extracting complex telemetry packets may include following steps S21 to S25.

In step S21, a memory space is initialized based on the configuration file, to construct a three-dimensional storage space for data structure units.

In one embodiment, *a*(*x*, *y, z*) represents any data structure unit in the three-dimensional storage space. (*x*, *y, z*) represents the z-th repetition of a *y*-th EPDU packet in an x-th virtual channel. Sub-spaces in the three-dimensional storage space are used to store each data structure unit.

In step S22, a first frame of downlink CADU packet is received.

In step S23, a VCDU packet is extracted from the first frame of downlink CADU packet, and state information of a virtual channel of the VCDU packet is determined.

In step S24, a header of a MPDU packet is acquired from the VCDU packet.

In step S25, a downlink EPDU packet is acquired based on a position indicated by the header of the MPDU packet, EPDU data in the downlink EPDU packet is dynamically written into a data storage region for a corresponding data structure unit.

A required packet is capable to be extracted by performing the above steps S21 to 25. Dynamic selection of stations is performed on the extracted telemetry packet based on the strategy of the unified time sequence, and redundant information is eliminated from the telemetry data source packet. Information of the data source packet serves as an initial condition for processing and interpreting the flight control data. The AOS packed telemetry method of the CCSDS includes four levels arranged from bottom to top, i.e. an organization of a source packet (EPDU), an organization of a multiplexer protocol data unit (MPDU), an organization of a virtual channel data unit (VCDU), and an organization of a channel access data unit (CADU).

Hereinafter data structures of an EPDU packet, an MPDU packet, a VCDU packet, and a CADU packet are described.

EPDU is an abbreviation of Encapsulation Protocol Data Unit. MPDU is an abbreviation of Multiplexer Protocol Data Unit. VCDU is an abbreviation of Virtual Channel Data Unit. CADU is an abbreviation of Channel Access Data Unit.

### (1) Data Structure of EPDU Packet (as shown in Table 1)

An EPDU packet (data source packet) is a basic unit for a packet in data transmission. A length of the EPDU packet remains unchanged after defined. The EPDU packet includes information of a packet header with a length of 6 bytes and information of a telemetry variable with a certain length, which are sequentially arranged. The length of the telemetry variable is clearly defined in the header of the EPDU packet. The application process identifier in Table 1 is configured to determine a packet name of the EPDU packet.

**Table 1. Data structure table of an EPDU packet**

| Main header (48 bits) | | | | | | | | Data field of packet |
|---|---|---|---|---|---|---|---|---|
| Packet identification | | | | | Packet sequence control | | Length of packet (n-1) | Source data |
| Version number | Source packet identifier | Type | Secondary header identifier | Application process identifier | Group identifier | Count of source packet in sequence | | |
| 1 | 2 | 1 | 1 | 11 | 2 | 14 | 16 | |
| 16 bits | | | | | 16 bits | | 16 bits | n bytes |

### (2) Data Structure of MPDU Packet (as shown in Table 2 and Table 3)

In the MPDU packet, multiple source packet data units EPDU are combined together in a certain format through a multiplexing service, so that multiple source packets are transmitted in one virtual channel. The source packets (EPDUs) are loaded in an end-to-end manner into a packet field of the MPDU packet. The packet field of the MPDU packet has a fixed length of (X+2) bytes, which is equal to a length of a data field in a virtual channel data unit (VCDU). The packet field occupies X bytes, and a header of the MPDU packet occupies 2 bytes.

**Table 2. Data structure table of an EPDU packet**

| Header of MPDU | | Packet field of MPDU | | | | |
|---|---|---|---|---|---|---|
| Backup (0000b) of 5bit | Initial header pointer of 11bit | End of a previous CCSDS packet #K | CCSDS packet #K+1 | ... | CCSDS packet #M | Start of a CCSDS packet # M+1 |

**Table 3. Value table of an initial header pointer of MPDU**

| Case | Initial header pointer | Meaning of packet field of MPDU |
|---|---|---|
| 1 | i (2≤i≤X+2) | Starting position of the first source packet is the i-th byte of this MPDU |
| 2 | 0x7ff (Custom variable) | MPDU has source packet data only and no source packet header |
| 3 | 0x7fe (Custom variable) | All is filled data |

The first case is a basic case. In the second case, the dynamic data is directly discarded in case of the first packet, and is combined with a previously stored packet header to form a completed packet in case of the second packet or a following packet. In the third case, the dynamic data is not processed when determined as the filled data.

### (4) Data Structure of VCDU Packet (as shown in Table 4)

The data structure of the VCDU packet includes a main header, an insertion field, a data field, and an error control field. The insertion field is configured to transmit important telemetry information isochronously. The error control field is configured to perform a CRC check on the entire frame of the VCDU packet. A length of the VCDU packet is in bytes, and is equal to a sum of the length of the MPDU packet data, a length of 6 bytes for a VCDU header, a length of M bytes for the insertion field, and a length of 2 bytes for a CRC check code. The length of M bytes is specified in the protocol.

**Table 4. Data structure table of an VCDU packet**

| | | | | | | | | |
|---|---|---|---|---|---|---|---|---|
| Main channel identifier | Count of virtual channel | Identifier field | Insertion field | Data field | Error control field | | | |

| Version number | Spacecraft identifier SCID | Virtual channel identifier VCID | frame | Spacecraft identifier (extended) | Backup | M Bytes | Byte | CRC check code |
|---|---|---|---|---|---|---|---|---|
| 2bits | 8bits | 6bits | 24bits | 4bits | 4bits | | | |
| 2Bytes | | | 3Bytes | 1Byte | | M Bytes | 205Bytes | 2 Bytes |

### Data Structure of CADU Packet

The CADU packet is formed by adding a synchronization flag of 4bytes in front of the VCDU packet. The synchronization flag depends on different models, and does not effect extraction of packets.

In one embodiment, an identification configuration table for the EPDU packet is further provided (as shown in Table 5).

**Table 5. Identification configuration table of an EPDU packet**

| First row in identification configuration table for telemetry E-PDU packet | Number (M) of corresponding EPDU packets in identification configuration table for telemetry E-PDU packet | | |
|---|---|---|---|
| Second row in identification configuration table for telemetry E-PDU packet | Identifier of E-PDU packet 1 | Packet number of E-PDU packet 1 | Length of a variable corresponding to E-PDU packet 1 |
| Third row in identification configuration table for telemetry E-PDU packet | Identifier of E-PDU packet 2 | Packet number of E-PDU packet 2 | Length of a variable corresponding to E-PDU packet 2 |
| ... | ... | ... | ... |
| (m+1)-th row in identification configuration table for telemetry E-PDU packet | Identifier of E-PDU packet m | Packet number of E-PDU packet m | Length of a variable corresponding to E-PDU packet m |

In this embodiment, a tagged word of the header of the EPDU packet is extracted by reading the identification configuration table for the EPDU packet. After feature word matching is performed, an EPDU packet corresponding to the feature word can be extracted through header matching during dynamic processing.

### Sub-module for dynamically selecting stations

In an embodiment, after receiving packet information of each station extracted by the sub-module for extracting complex telemetry packets, the sub-module for dynamically selecting stations automatically performs temporal alignment and redundancy elimination information among multiple sources of telemetry information, which include redundant information and are asynchronous in timing. Accordingly, a real-time telemetry packet that meets a temporal requirement is obtained. A telemetry packet T is taken as an example to describe a process of dynamic selection of the station based on the unified time sequence.

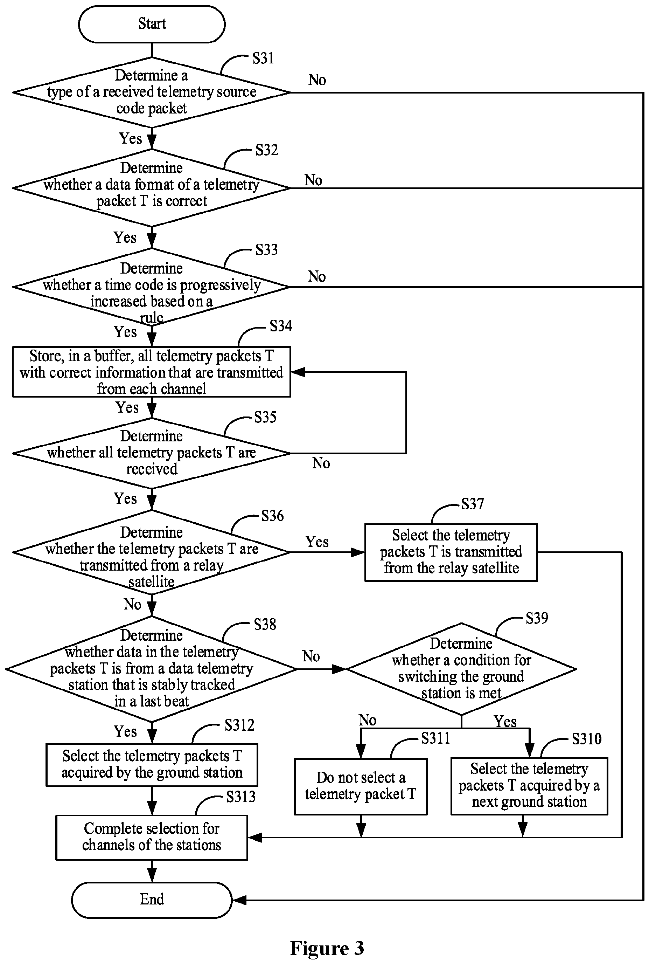

Reference is made to Figure 3, which is a schematic diagram of an operation flow of a sub-module for dynamically selecting stations according to an embodiment of the present disclosure. The operation flow of the sub-module for dynamically selecting stations may include following steps S31 to S313.

In step S31, a type of a received telemetry source code packet is determined. The flow goes to step S32, in a case that the received telemetry source packet is the telemetry packet T. The flow goes to an end of data processing for the telemetry packet T, in a case that the received telemetry source packet is not the telemetry packet T.

In step S32, it is determined whether a data format of the telemetry packet T is correct. The flow goes to step S33, in a case that the data format of the telemetry packet T is correct. The flow goes to an end of data processing for the telemetry packet T, in a case that the data format of the telemetry packet T is incorrect.

In step S33, a time code is extracted from the telemetry packet T that is acquired from the ground station or a relay satellite, and it is determined whether the time code is progressively increased based on a rule. A telemetry packet T which meets a progressive increase of the incremental time code is stored, and the flow goes to step S34. Data that is unchanged or reduced in the time code is determined as invalid data, and the flow goes to an end of data processing for the telemetry packet T.

In step S34, all telemetry packets T with correct information that are transmitted from each channel are stored in a buffer, and the flow goes to step S35.

In step S35, it is determined whether all telemetry packets T are received. The flow returns to step S34, in a case that not all telemetry packets T are received. The flow goes to step S36, in a case that all telemetry packets T from each are received.

In step S36, it is determined whether the telemetry packets T are transmitted from the relay satellite. The flow goes to step S37, in a case that the telemetry packets T are transmitted from the relay satellite. The flow goes to step S38, in a case that the telemetry packets T are not transmitted from the relay satellite.

In step S37, the telemetry packets T is transmitted from the relay satellite are selected as an output of real-time data, and flow goes to step S313.

In step S38, it is determined whether data in the telemetry packets T is from a data telemetry station that is stably tracked in a last beat. The flow goes to step S312, in a case that the data in the telemetry packet T is from such stably tracked data telemetry station. The goes to step S39, in a case that the data in the telemetry packet T is not from such stably tracked data telemetry station.

In step S39, it is determined whether a condition for switching the ground station is met. The flow goes to step S310, in a case that the condition is met. The flow goes to step S311, in case that the condition is not met.

In step S310, the telemetry packets T acquired by a next ground station is selected, and the flow goes to step S313.

### In step S311, no telemetry packet T is selected, and the flow goes to step S313.

In step S312, the telemetry packets T acquired by the ground station is selected, and the flow goes to step S313.

In step S313, selection for channels of the stations is completed.

**The module 102 for simulation and verification in flight control** is configured to: acquire an initial condition for simulation and verification, from a module for fusing and processing multi-source data; perform simulation and verification for a flight control scheme, to obtain simulation and verification data for the flight control scheme; perform simulation and verification for control software, to obtain simulation and verification data for the control software; perform physical verification for a target machine, to obtain verification result data for the target machine; and transmit the simulation and verification data for the flight control scheme, the simulation and verification data for the control software, and the verification result data for the target machine to the module for fusing and processing multi-source data.

In one embodiment, the module 102 for simulation and verification in flight control may include a sub-module for simulation and verification of flight control schemes, a sub-module for simulation and verification of control software, and a sub-module for target-machine physical verification. The sub-module for simulation and verification of flight control schemes is configured to: perform simulation and verification for the flight control scheme, with on-orbit data of the flight control obtained from the module for fusing and processing multi-source data as an initial condition, to obtain the simulation and verification data for the flight control scheme; analyze the simulation and verification data for the flight control scheme, or transmit the simulation and verification data for the flight control scheme to the module for fusing and processing multi-source data for comparison with the real-time flight control data. The simulation and verification for the flight control scheme includes: verifying in advance a critical function for safety of the flight control, Monte Carlo experiment and bias test. The sub-module for simulation and verification of control software is configured to: perform, for a flight mission, quick verification on software of a software simulation platform for the flight control, with the on-orbit data of the flight control obtained from the module for fusing and processing multi-source data as an initial condition, to obtain an operation state of the software under a corresponding condition as the simulation and verification data for the control software; and transmit the simulation and verification data for the control software to the module for fusing and processing multi-source data for comparison with the real-time flight control data. The sub-module for target-machine physical verification is configured to: test and verify the flight mission, with the on-orbit data of the flight control obtained from the module for fusing and processing multi-source data as an initial condition, to obtain verification result data for the target machine; and analyze the verification result data for the target machine, or transmit the verification result data for the target machine to the module for fusing and processing multi-source data for comparison with the real-time flight control data.

### Sub-module for simulation and verification of flight control schemes

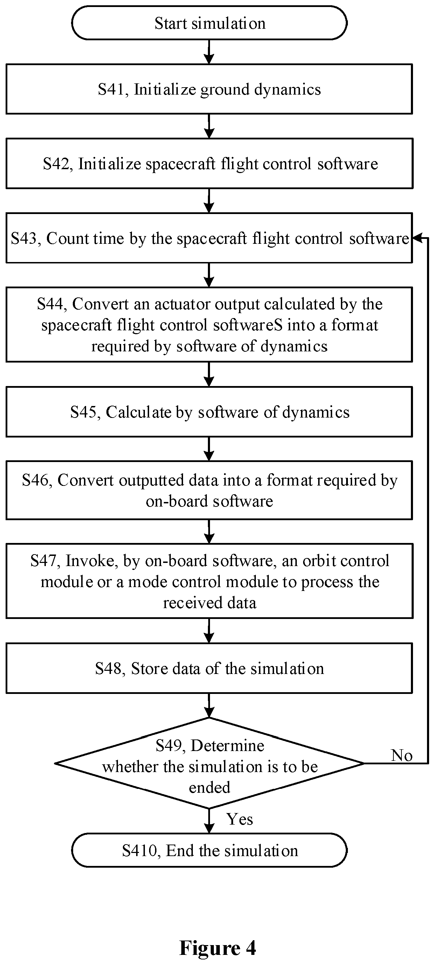

In one embodiment, software of ground dynamic simulation is a core of a simulation and verification environment for the flight control scheme. The ground dynamics is linked with spacecraft flight control software via a customized interface. The spacecraft flight control software is an object to be tested. Reference is made to Figure 4, which is a schematic diagram of an operation flow of a sub-module for simulation and verification of flight control schemes according to an embodiment of the present disclosure. The operation flow of the sub-module for simulation and verification of flight control schemes may include following steps S41 to S410.

### In step S41, the ground dynamics is initialized.

Initializing the ground dynamics generally includes setting an initial attitude angle, an attitude angular velocity, a step size for dynamics simulation, an initial angular momentum of a wheel, a switching state of a component, an initial track parameter, a simulation duration, and the like.

In step S42, the spacecraft flight control software is initialized.

Initializing the spacecraft flight control software generally includes setting an absolute spacecraft-clock time, an initial orbit parameter, an initial pattern word, and an initial configuration parameter. In one embodiment, a module for initializing on-board software may be directly invoked for the initialization, and simulation is performed in a closed loop after the initialization.

In step S43, the spacecraft flight control software performs time counting.

In one embodiment, spacecraft-clock time is counted for the spacecraft in each cycle of the simulation.

In step S44, an actuator output calculated by the spacecraft flight control software is converted into a format required by software of dynamics.

In one embodiment, data for an actuator (such as output data for a thruster, a momentum wheel, or a magnetic-torquer) that is calculated and outputted by on-board software is converted into the format required by the software of dynamics via a conversion interface, and the converted data is inputted into the software of dynamics.

In step S45, the software of dynamics performs calculation.

In one embodiment, the software of dynamics (simulation) is invoked in each cycle, to perform dynamics simulation and kinematics simulation, and output a dynamics attitude, an orbit parameter, and data of each sensor.

In step S46, data outputted in the step S45 is converted into a format required by the on-board software.

In one embodiment, the data outputted in the step S45 is converted into the data format required by the on-board software via a conversion interface. The converted data inputted into the on-board software.

In step S47, the on-board software invokes an orbit control module or a mode control module to process the received data.

In one embodiment, the on-board software invokes the orbit control module or the mode control module to process the data transmitted in step S46 (for example, determine an attitude, calculate for a controller, or perform mode processing), so as to generate a new actuator output.

In step S48, data of the simulation is stored.

In one embodiment, the stored simulation data may be transmitted to the module for fusing and processing multi-source data on requirement.

In step S49, it is determined whether the simulation is to be ended.

In one embodiment, the flow goes to step S410 in a case that the simulation is to be ended, or goes to step S43 in a case that that the simulation is not to be ended.

In step S410, the simulation ends.

As describe above, the sub-module for simulation and verification of flight control schemes simulates an environment of a CPU and an external interface that is run by real software, via a full digital simulator, with the on-orbit data of the flight control that is obtained from the module for fusing and processing multi-source data as an initial condition (or, with another specified initial data as an initial condition). In a specified condition, the sub-module for simulation and verification of flight control schemes verifies the control software for rendezvous and docking software, and verifies the logic in receiving instructions for data injection, processing mode switching, and performing an operating action. The verification is controlled by the full digital simulator. The control software of the simulation interprets and executes a computer instruction set, based on a running state of software in reality. A running speed is increased by 20 times in comparison with a normal operation under a ratio of 1:1. Thereby, fast simulation of software running logic, and fast simulation and verification of operating processing logic are achieved. Verification data is acquired through the simulation and verification for the control software, and the acquired verification data is analyzed. The verification data is transmitted to the module for fusing and processing multi-source data, and is compared with the simulation and verification data for the flight control scheme and the verification result data for the target machine. Afterwards, steps and corresponding injection data that are subjected to the simulation and verification are provided for real-time flight control, and the simulation and verification data is further provided in comparison with the real-time data of the flight control.

### Sub-module for target-machine physical verification

In one embodiment, the sub-module for target-machine verification is a semi-physical simulation environment including a real spacecraft control computer. A satellite-ground combined test is an effective means of debugging and testing during development of application software for an on-board control computer, and is an important means for verifying the flight control in advance. The sub-module for target-machine verification can simulate, dynamically and realistically, a process of controlling an orbit and an attitude of an on-orbit satellite or spacecraft in real time, and can test a function and a performance of the application software for the on-board computer effectively. A target-machine for the on-board computer software is a real on-board computer. Therefore, the satellite-ground combined test is actually a simplified system test. The on-board computer simulates a real object, dynamics, and components via the software. An input to a sensor of the spacecraft is excited by a digital signal, and satellite dynamics is simulated and calculated by a ground computer, and a real-time closed-loop system is formed. A running state of the simulation system is completely consistent with an on-orbit flight state of the spacecraft in time sequences, command chains and coordination among components. The simulation system is a core part for implementing flight simulation and verification, and may simulate and reproduce complete on-board states with a time sequence under a ratio of 1:1. The target-machine verification is capable to verify running of the spacecraft flight control software in advance, under an on-orbit operating condition that is most approximate to reality. A basis for decision is provided by analyzing the data acquired from the target-machine verification.

**The module 103 for fusing and processing multi-source data** is configured to automatically parse real-time flight control data, the simulation and verification data for the flight control scheme, the simulation and verification data for the control software, the verification result data for the target machine, and flight data of history rendezvous and docking missions that are transmitted to the module for fusing and processing multi-source data, and store the parsed data in a module for memory-database processing. The module 103 for fusing and processing multi-source data is further configured to transmit required data to a specified module in the support system, and trigger a corresponding operation of such module.

In one embodiment, the module 103 for fusing and processing multi-source data includes a sub-module for fusing multi-source data, a sub-module for data acquisition, a sub-module for dynamic setting, and a sub-module for history flight data. The sub-module for fusing multi-source data is configured to: parse automatically the real-time flight control data, the simulation and verification data for the flight control scheme, the simulation and verification data for the control software, the verification result data for the target machine, and the flight data of history rendezvous and docking missions; and store the parsed data in the module for memory-database processing. The sub-module for data acquisition is configured to read feature information of a predefined configuration file, and acquire independent data of a corresponding variable at a specified moment or an array of data of the corresponding variable within a continuous period. The sub-module for dynamic setting is configured to generate a new variable required in the flight control mission by operating on an interface or linking to a dynamic library, generate a configuration file based on the new variable required in the flight control mission, and load configuration information in the configuration file dynamically to a storage sequence. The sub-module for history flight data is configured to store a typical process and typical state data of the flight control, and provide basic data for comparison in data processing of the module for intelligent analysis in flight control.

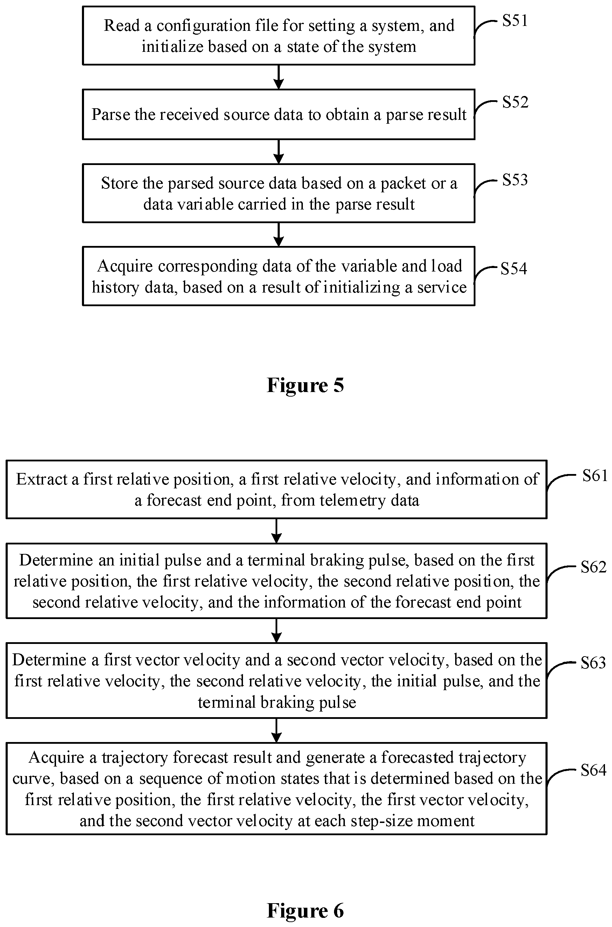

Reference is made to Figure 5, which is a schematic diagram of an operation flow of a module for fusing and processing multi-source data according to an embodiment of the present disclosure. The operation flow of the module for fusing and processing multi-source data may include steps S51 to S54.

In step S51, a configuration file for setting a system is read, and initialization is performed based on a state of the system.

In one embodiment, the initialization includes initializing a memory database and initializing a service. In one embodiment, the step S51 may include the following steps A1 to A9. In step A1, a configuration file for a memory database is read, and predefined information is processed. For each data source, an IP address and a port number correspond to the source packet data, and a storage path and a file name of the configuration file of the source packet data, are mapped to each other in the memory database. An interval for data storage, a trigger condition for data storage, and a maximum memory in the memory database are initialized. In step A2, an independent space is established in the memory for each variable in the configuration file of the source packet. The independent space is configured to store an array for parameter storage data, and thereby it is ensured that the stored array of variables is kept continuous in a physical space of the memory. In step A3, an event-driven model is initialized. The event-driven model includes a model driven by an IO event and a model driven by a timer event. In step A4, master-slave initialization is performed. Thereby, it is ensured that connection is established between a slave end "slave" and a master end "master" in the system after the slave end "slave" is started, so as to transmit a synchronization command and acquire data. In step A5, a rule for data interpretation is initialized, and the interval for data storage and a criterion for determining a data change in the configuration file are processed. In step A6, a name, a length, an IP address, a configuration file path, and sampling frequency information of the source packet are read from the source packet of the data source, to generate a structure body for describing feature information of the data source packet. In step A7, parameter information is read from the source packet to generate a sequence of arrays. The name of the source packet serves as a name of the sequence, and elements in the sequence are code numbers for each parameter in the source packet. In step A8, a sequence of the read name of the source packet data and a sequence of source packet parameter data are written into the memory database. A sequence of a list of parameters is created for each telemetry packet. A key of the sequence is the name of the source packet, and a value of the sequence is an array of names of all telemetry parameters included in the telemetry packet. A sequence of values of parameter is created for each telemetry parameter. A key is the name of the parameter, and a value is an array of a value of the parameter. In step A9, all system operation flags and data playback flags for controlling an operation state are reset.

In step S52, the received source data is parsed to obtain a parse result.

In one embodiment, the step S52 may include following steps B1 to B15. In step B15, configuration files corresponding to the source packet data are sequentially acquired, and feature information required in predefined data parse is extracted from the files. In step B2, a quantity of to-be-parsed data corresponding to a telemetry information stream in a first row of a configuration file of a selected data source packet is read as an Arabic number, and the Arabic number represents that the quantity of to-be-parsed data in all telemetry downlink data. The quantity of to-be-parsed data corresponding to the telemetry information stream is N. In step B3, mapping is performed. After the quantity of to-be-analyzed data is read, it is determined whether the quantity of to-be-analyzed data is correctly correlated to the whole telemetry download information stream. The process goes to step B13, in a case that the quantity of to-be-analyzed data is not correctly correlated to the whole telemetry download information stream. The process goes to step B4, in a case that the quantity of to-be-analyzed data is correctly correlated to the whole telemetry download information stream. In step B4, a counter is set as M=2. In step B5, it is determined whether M is less than the total quantity (N+1) of rows in the configuration file. The process goes to step B 14, in a case that M is not less than the total quantity of rows in the configuration file. The process goes to step B6, in a case that M is less than the total quantity of rows in the configuration file. In step B6, a name of to-be-parse data in an M-th row in the configuration file is read, to obtain to-be-analyzed data M-1. In step B7, a length of basic feature information of the M-th row in the configuration file is read, and data with the corresponding length are sequentially selected from a telemetry download data stream. In step B8, the selected data is processed into a sequence with higher bits ahead of lower bits, based on an order from a high byte to a low byte of the basic feature information in the M-th row. In step B9, the data is processed into a corresponding format based on a data type of the basic feature information in the M-th row. In step B10, the processed data is multiplied by a corresponding equivalent of the basic feature information in the M-th row. In step B11, the obtained data is combined with a unit of the basic feature information in the M-th row, to form a complete parsed value. In step B12, the counter is set as M=M+1, and the process returns to step B5. In step B13, it is displayed that the configuration file does not match the telemetry information stream, and an alarm is triggered. In step B14, it is determined whether the telemetry data file of the source packet is completely processed. The process returns to step B1 to process next source packet data, in a case that the telemetry data file of the source packet is not completely processed. The process goes to step B15, in a case that the telemetry data file of the source packet is completely processed. In step B15, parsing on all packets is completed.

In step S53, the parsed source data is stored based on a packet or a data variable carried in the parse result.

In one embodiment, the step S53 may include following steps C1 to C11. In step C1, telemetry source packet data from multiple channels specified in initializing the memory database is received periodically. In step C2, a data source code is dynamically refreshed in real time after being parsed, based on a correspondence relationship in automatic parsing. In step C3, parameter values of a variable that are dynamically refreshed in real time are sequentially stored in a buffer corresponding to the variable. In step C4, it is determined whether a quantity of parameters of the variable stored in the buffer reaches a preset number N. The process returns to step C3, in a case that the quantity of parameters of the variable stored in the buffer of the memory database does not reach the preset number N. The process goes to step C5, in a case that quantity of parameters of the variable stored in the buffer of the memory database reaches the preset number N. N represents a quantity of variables stored in the buffer of the memory database. In step C5, the N parameters of the variable in the buffer are packed into a data block. In step C6, the data block is sequentially stored into a continuous space for the variable in the memory database, the buffer for the variable is cleared, and a pointer of the buffer is moved to an initial position. In step C7, the data of the variable is compressed and then solidified to a hard disk via an IO interface, when data newly stored for the variable reaches a set proportion of the buffer in the memory database. In step C8, it is determined whether a quantity of variables stored in the memory database reaches M. The process returns to step C3 in a case that the quantity of variables in the memory database does not reach M. The process goes to step C9 in a case that the quantity of variables in the memory database reaches M. In step C9, the memory database is cleared, and a pointer for storage space in the memory database is moved to an initial position. In step C10, it is determined whether variables subject to automatic parsing have been stored for the configuration files corresponding to all data source packets. The process returns to step C2, in a case that variables subject to automatic parsing have not been stored for the configuration files corresponding to all data source packets. The process goes to step C11, in a case that variables subject to automatic parsing have been stored for the configuration files corresponding to all data source packets. In step C11, it is determined whether the data storing is to be ended. The process returns to step C1, in a case that the data storing is not to be ended. The current data storage ends, in a case that the data storing is to be end.

In step S54, corresponding data of the variable is acquired, and history data is loaded, based on a result of initializing the service.

In one embodiment, the step S54 may include following steps D1 to D7. In step D1, configuration of an export parameter is read. In step D2, an export file is created. In step D3, a header of export data is generated. In step D4, it is determined whether all data rows in the memory database have been exported. The process goes to step D7, in a case that all data rows in the memory database have been exported. Otherwise, the process goes to step D5. In step D5, a reference time for each cycle is written. In step D6, data of the to-be-acquired variable of a single row is written, and the process returns to step D4. In step D7, the file is closed after the data has been stored, and the data acquisition ends.

In one embodiment, the step S54 may include following steps E1 to E8. In step E1, a historical data path and a simulation data path are acquired. In step E2, it is determined whether the paths are successfully acquired. The process stops and the data loading ends, in a case that the paths are not successfully acquired. The process goes to steps E3, in a case that the paths are successfully acquired. In step E3, the current memory database is closed. In step E4, a template file for configuring the memory database is dynamically modified, and a to-be-loaded variable is added into the memory database. In step E5, selected data is loaded. In step E6, a real-time memory database is initialized based on the configuration template file that is dynamically modified and initialized. In step E7, the interface is reset, the timer is re-initialized, and a display window is initialized. In step E8, history data and simulation data are displayed, a real-time data state is refreshed, and the data loading is completed.

**The module 104 for memory-database processing** is configured to solidify the parsed data to a hard disk at each set time interval, via a hardware interface.

Reference is made to Table 6, which is a schematic table of a variable storing in the module for memory-database processing according to an embodiment of the present disclosure.

**Table 6**

| | | | | | |
|---|---|---|---|---|---|
| Variable sequentially stored after automatically parsed | Data1 stored in buffer | ... | DataN stored in buffer | | |
| | Data1 stored in memory | ... | ... | ... | DataM stored in memory |

As shown in Table 6, the buffer and the memory for the data are a continuous physical storage space. Specific content of the variable is stored in the continuous physical storage space. A manner of data storage is the memory database, in which effective data occupies a high proportion, and storage efficiency is high. Values of N and M may be adjusted based on a requirement in practice. M is set to meet a task requirement for long-term continuous observation and real-time data comparison. M is an integer multiple of N, so as to reduce complexity for loading and processing data. N is usually small, so that each duration in which the data is transmitted from the buffer to the memory is undetectable on a monitoring display. A good effect of human-computer interaction is ensured.

In one embodiment, the data in the memory database is solidified to the hard disk via the hardware interface at each set time interval. A performance of processing large amounts of data in real time is greatly improved in comparison with the conventional technology. A requirement of pre-estimation and forecast of real-time data is met on fast acquisition of any data throughout the process.

Reference is made to Table 7, which is a table for comparing and analyzing data processing efficiency according to an embodiment of the present disclosure.

**Table 7**

| **Items** | **Embodiment of the present disclosure** | **Conventional technology** |
|---|---|---|
| Storage method | Data is directly stored in memory with a high rate of 50GB/s | Data is directly stored in a hard disk, and is read and written via a hardware port with a slow rate of 550MB/s |
| Data processing | Multi-source data is managed in a unified manner, and multiple variables are quickly compared | Data is managed in a decentralized manner, and variables cannot be effectively compared in real time |
| Overall layout for data storage and method for storing parameter | Parameters are stored based on names of the parameters, and are stored is a continuous physical space, and M parameters are continuously stored | Parameters are stored by packets and are stored with intervals in the physical memory space, and one parameter is stored each time |
| Method for reading data | Parameters are read quickly and continuously | Parameters in the packet are read and cannot be read continuously, and one parameter is read each time |
| Method for loading data | Compressed variables are loaded from the hard disk into the memory via a hardware interface, and are acquired by reading memory data | Parameters are loaded directly and are read directly from the hard disk. |
| Storage efficiency for history data | Data file is small in size after being compressed | Data file is large in size without compression |

In one embodiment, the module 104 for memory-database processing is generally used in combination with the module 103 for fusing and processing multi-source data.

**The module 105 for intelligent analysis in flight control** is configured to monitor and analyze the real-time flight control data, the simulation and verification data for the flight control scheme, and the simulation and verification data for the control software that are acquired from the module for fusing and processing multi-source data, and pre-estimate and forecast a trajectory curve.

In this embodiment, the module 105 for intelligent analysis in flight control includes a sub-module for monitoring real-time states, a sub-module for interpreting intelligent data, and a sub-module for forecasting flight states. The sub-module for monitoring real-time states is configured to monitor information of a real-time flight state, and obtain real-time data of a key data variable in the flight control. The real-time data of the key data variable in the flight control includes orbit information, attitude information, sensor state information, sensor measurement information, and actuator data. The sub-module for interpreting intelligent data is configured to perform intelligent data analysis based on states of simulation data, history data, and real-time flight data, and provide support data for interpretation in a support operation for the flight control decision. The sub-module for forecasting flight states is configured to pre-estimate and forecast the trajectory curve, with real-time on-orbit flight data as an initial condition. Thereby, a forecast result for a state of the flight control is obtained before a key event, and decision support is provided for determination in advance in a flight control mission.

### Sub-module for monitoring real-time states

In one embodiment, reference is made to Figure 6, which is a schematic diagram of an operation flow of a sub-module for monitoring real-time states according to an embodiment of the present disclosure. The operation flow of the sub-module for monitoring real-time states may include following steps S61 to S64.

In step S61, a first relative position, a first relative velocity, and information of a forecast end point, are extracted from the telemetry data.

In one embodiment, the first relative position and the first relative velocity may be a relative position and a relative velocity of the spacecraft in a relative navigation coordinate system. The information of the forecast end point includes a end point for pre-estimation and forecast, and a second relative position and a second relative velocity at the end point for pre-estimation and forecast.

In step S62, an initial pulse and a terminal braking pulse are determined based on the first relative position, the first relative velocity, the second relative position, the second relative velocity, and the information of the forecast end point.

In one embodiment, the step S62 may be implemented as follows. A target point in relative motion at a next moment is determined based on the first relative position and the first relative velocity. It is determined whether the end point for pre-estimation and forecast is in front of the target point in relative motion at the next moment. In a case that the end point for pre-estimation and forecast is in front of the target point in relative motion at the next moment, the initial pulse and the terminal braking pulse required from the first relative position and the first relative velocity to the second relative position and the second relative velocity is calculated through a dynamics equation of relative motion. In a case that the end point for pre-estimation and forecast is not in front of the target point in relative motion at the next moment, the end point for pre-estimation and forecast is adjusted until located in front of the target point in relative motion at the next moment, when the end point for pre-estimation and forecast is allowed to be adjusted based on a flight strategy.

In step S63, a first vector velocity and a second vector velocity are determined based on the first relative velocity, the second relative velocity, the initial pulse, and the terminal braking pulse.

In one embodiment, step S63 may be implemented as follows. The first relative velocity and the initial pulse are added in vectors, to obtain a first vector velocity. A calculation duration for trajectory forecast is reset to zero. It is determined whether a length of output data is less than a set threshold, based on a current step size in calculation and a total forecast duration. In a case that it is determined that the length of the output data is less than the set threshold, a relative position and a relative velocity of the spacecraft in the relative navigation coordinate system are calculated for a next step-size moment, and accumulation is made to the calculation duration for trajectory forecast. It is determined whether the calculation duration for trajectory forecast is greater than the total forecast duration. In a case that it is determined that the calculation duration for trajectory forecast is greater than the total forecast duration, the relative velocity of the spacecraft in the relative navigation coordinate system at the next step-size moment and the terminal braking pulse are added, to obtain a second vector velocity. In a case that it is determined that the length of the output data is greater than or equal to the set threshold, the step size for the equation of relative motion is adjusted until the length of the output data is less than the set threshold. In a case that it is determined that the calculation duration of trajectory forecast is less than or equal to the total forecast duration, the relative position and the relative velocity of the spacecraft in the relative navigation coordinate system are calculated for the next step-size moment, and accumulation is made to the calculation duration for trajectory forecast, until the calculation duration for trajectory forecast is greater than the total forecast duration.

In step S64, the trajectory forecast result is acquired, and a forecasted trajectory curve is generated, based on a sequence of motion states that is determined based on the first relative position, the first relative velocity, the first vector velocity, and the second vector velocity at each step-size moment.

In one embodiment of the present disclosure, the module 105 for intelligent analysis in flight control is further configured to provide a standardized interface, via which an external plugin exchanges data with the module for intelligent analysis in flight control.

**The module 106 for decision support in flight control** is configured to perform a support operation for a flight control decision by interpreting a condition and a state, based on data that are transmitted from the module for acquiring and processing real-time data in flight control, the module for simulation and verification in flight control, and the module for intelligent analysis in flight control, to the module for fusing and processing multi-source data.

In this embodiment, the module 106 for decision support in flight control includes a sub-module for automatic decision processing in normal flight control procedure, a sub-module for safety pre-warning processing, and a sub-module for fault emergency processing. The sub-module for automatic decision processing in normal flight control procedure is configured to: extract, based on the flight mission, data required in the flight mission from the module for fusing and processing multi-source data, and generate uplink injection data based on the extracted data required in the flight mission; determine the data required in the flight mission and the uplink injection data as input data, and trigger the module for simulation and verification in flight control to simulate and verify the uplink injection data, to obtain a result of simulation and verification; upload the uplink injection data that is verified to the spacecraft, via the module for fusing and processing multi-source data that acquires the result of simulation and verification outputted by the module for simulation and verification in flight control; and acquire an operating result of the spacecraft, which is based on the uplink injection data that is verified, and verify again, based on the operating result, the uplink injection data that is verified. The result of simulation and verification, which is outputted by the module for simulation and verification in flight control and acquired by the module for fusing and processing multi-source data, includes the uplink injection data that is verified through the simulation and verification. The data required in the flight mission includes: spacecraft attitude information, orbit information, and health information of an operation state. The sub-module for safety pre-warning processing is configured to: acquire safety state information of the spacecraft, safety corridor information of an orbit, and health state information of a sensor actuator, from the module for fusing and processing multi-source data; compare the safety state information of the spacecraft, the safety corridor information of the orbit, and the health state information of the sensor actuator with thresholds, respectively; and perform safety pre-warning based on a result of the comparing. The sub-module for fault emergency processing is configured to: acquire information of a sudden emergency fault during the flight mission, from the module for fusing and processing multi-source data; select a contingency plan for the sudden emergency fault, where the contingency plan matches the information of the sudden emergency fault; determine whether the sudden emergency fault is eliminated after executing the sudden emergency fault contingency plan; and trigger the sub-module for safety pre-warning processing, in a case that the sudden emergency fault is eliminated.

### Sub-module for automatic decision processing in normal flight control procedure

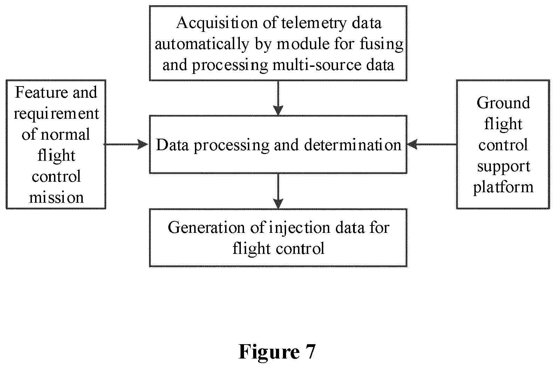

Reference is made to Figure 7, which is a schematic diagram of processing in an automatic decision for a normal flight control procedure according to an embodiment of the present disclosure. The sub-module for automatic decision processing in normal flight control procedure is configured to perform decision for a normal flight mission. The normal flight control procedure refers to a procedure that cannot be automatically processed on-board according to a flight mission, and the normal flight control procedure is implemented with ground assistance. A task list of ground-assisted decisions that are required in normal flight control includes: introduction and switching of a sensor, check and injection of an injected orbit, injection of an orbit transfer parameter, selection of a flight mode, introduction of a relative sensor, backup protection strategy for safety of rendezvous and docking, configuration of a key parameter for rendezvous and docking, and the like.

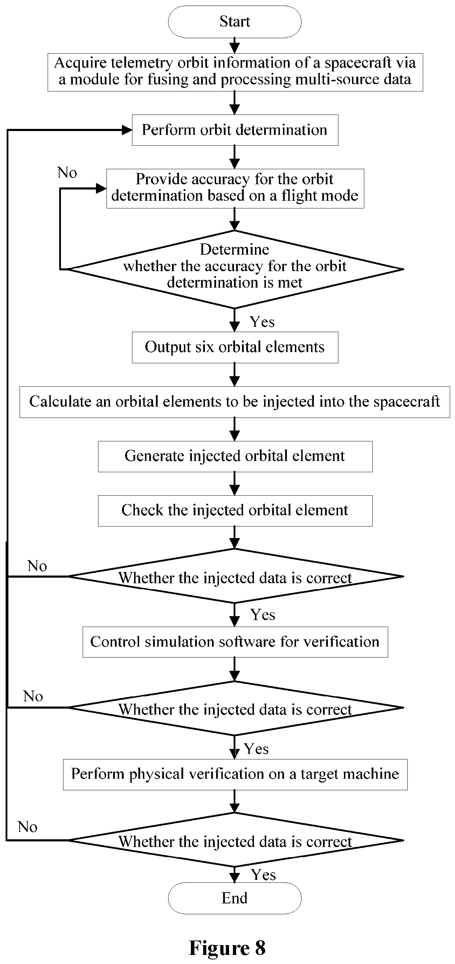

The verification and injection of an injected orbit is taken as an example. Reference is made to Figure 8, which is a schematic diagram showing of automatic decision of a normal flight control procedure according to an embodiment of the present disclosure. An operation flow of the sub-module for automatic decision processing in normal flight control procedure may include following steps. (1) A key parameter for a task requiring intervention is determined according to a feature and a requirement of the task. The key parameter for the check and injection of the injected orbit is a to-be-injected orbital element. (2) Telemetry information required in checking and injecting the orbital element is acquired based on a function of multi-source heterogeneous data. The required telemetry information is orbit data. Acquisition information of an orbit generally requires data in 2 to 3 periods of the orbit, and 10 minutes may be adequate in a case only coarse information of the orbit is required. (3) Data processing and determination are performed. The verification and injection of the injected orbit is performed by invoking support software of ground flight control to calculate and verify the orbital element, which includes following steps. Orbit determination is performed in real time for the orbit, based on the telemetry orbit information. The to-be-injected orbital element is calculated based on a result of the orbit determination. (4) Injection data for the flight control is generated and verified. The to-be-injected orbital element is required to be generated for the verification and injection of the injected orbit. Injection data is coded based on a result in item (3), and the calculated injection data is verified by verification software. In a case that the calculated injection data is verified, the simulation and verification is performed by control software, and the physical verification is performed on the target machine.

In an embodiment of the present disclosure, the system for intelligent data analysis and decision support in spacecraft rendezvous and docking flight control further includes a module 107 for displaying curves and processing interface operations.

**The module 107 for displaying curves and processing interface operations** is configured to display multi-source heterogeneous data corresponding to the support operation as a curve, refresh the multi-source heterogeneous data on an interface periodically or for once, to enable the multi-source heterogeneous data to be adjustable along a horizontal axis and a vertical axis. Thereby, comparison and analysis of the data are facilitated.

In one embodiment, the module 107 for displaying curves and processing interface operations includes a sub-module for display curves and a sub-module for interface operations. The sub-module for display curves is configured to refresh, periodically or for once, the multi-source heterogeneous data corresponding to the support operation for the flight control decision on the interface, to enable the multi-source heterogeneous data to be adjustable along a horizontal axis and a vertical axis. The comparison and analysis of the data is facilitated, and a scene of visual display is provided for data processing. The sub-module for interface operations is configured to provide a function option for managing a configuration file, a function option for storing data, a function option for extracting data, a function option for displaying a curve, a function option for data calculation, and a function option for linking to a dynamic processing library.

Based on the above embodiments, feature information of data to be processed is abstracted as multiple configuration files by the system for intelligent data analysis and decision support in spacecraft rendezvous and docking flight control according to an embodiment of the present disclosure. Feature information of the multiple configuration files are read to process the related data, and the related data is operated and processed in a unified manner. The system has advantages of good versatility and easy maintenance. Further, the configuration file can be quickly modified without changing a processing logic of the system, in a case that there is a change in a variable, a quantity of variables changes, or a data channel during the flight control process. Thereby, the system is adapted to a requirement of a flight control mission on quick changes and simple maintenance. In addition, the system for intelligent data analysis and decision support in spacecraft rendezvous and docking flight control can read a parameter configuration file, correlate data in the received multi-source packets with each variable predefined in the configuration file, acquire all predetermined variables through automatic parsing, predefine the variables, compare in real time data of the variables obtained through algorithm processing and the pre-estimation and forecast, and store such variables to the memory database.

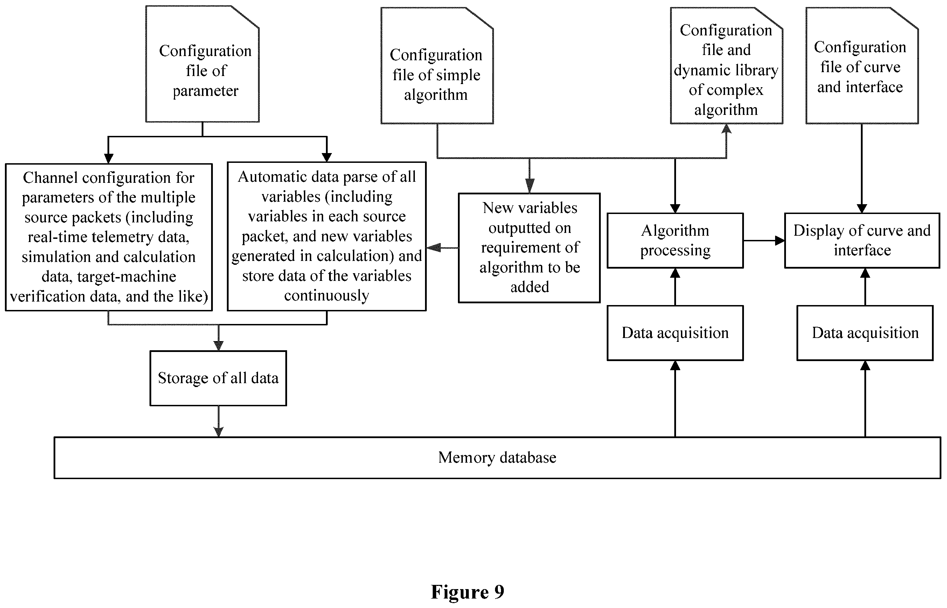

In one embodiment, a manner of data processing and a relationship with a configuration file are as shown in Figure 9 for a system for intelligent data analysis and decision support in spacecraft rendezvous and docking flight control. A parameter configuration file includes multiple configuration files of two types, namely, channel configuration information for multiple source packets and data analysis information for each variable in a source packet.

A first type of configuration file (of which a quantity is 1) is the channel configuration information for the multiple source packets. Such type includes channel configuration information for parameters of the multiple source packets (including real-time telemetry data, simulation and calculation data, target-machine verification data, and the like). The channel configuration information for parameters includes information of a network node as a source, channel information, packet length information, packet transmission cycle information, and the like, for each source data. Real-time flight control telemetry data is taken as an example for illustration. It is assumed that the real-time telemetry data is acquired from a network node of 192.168.1.1, and the real-time flight control telemetry data has three corresponding packets, namely, a packet 1, a packet 2 and a packet 3. Lengths of the three packets are N1 bytes, N2 bytes, and N3 bytes, respectively. The three packets apply an UDP network protocol with channel numbers of 8000, 8001, 8002, respectively. There is also storage cycle information of each packet. The aforementioned information is included in the configuration file. The system for intelligent data analysis and decision support in spacecraft rendezvous and docking flight control is capable to acquire such information by processing the configuration file. A data stream acquired from the configuration file is associated with the variables to be parsed, so as to provide a correspondence between the packets to be parsed and the received data.

A second type of configuration file (of which a quantity is more than one) is a data analysis configuration file. The data configuration file includes feature information of all variables corresponding to a single packet included in each configuration file. The data configuration file is configured to automatically parse each variable in such packet. All variables include variables in each source packet, and further include new variables generated in calculation. Data of all variables are stored continuously in a real-time database after being parsed.

A packet of the real-time telemetry data of the flight control is taken as an example, and a format of the packet is as shown in Table 8. The data configuration file includes four parts. A first part includes a quantity (N) of decoding variables corresponding to a information stream in bytes. A second part includes a name of data to be parsed. A third part includes basic feature information. A fourth part includes expandable feature information. A parameter of expandable feature may include an upper limit and a lower limit for tolerance, and the like. The parameter of expandable feature provides an expanded concept for such type of data parsing. For data comparison and other purposes, a data expansion function with a wide application may be achieved by defining the feature information and designing an operation matching the definition. Thereby, data processing with good expandability is provided, to improve data analysis capability of the present disclosure.

**Table 8. Schematic table of a data configuration file**

| First row in configuration file | 1. Quantity (N) of decoding variables corresponding to a information stream in bytes | | | | | | | | |
|---|---|---|---|---|---|---|---|---|---|
| | 2. Name of data to be parsed | 3. Basic feature information | | | | | 4. Expandable feature information | | |
| Second row in configuration file | To-be-parsed data 1 | Quantity of bits | An order from high bit to low bit | Type of data | Equivalent | Data unit | Lower tolerance limit | Upper tolerance limit | ... ... |
| Third row in configuration file | To-be- parsed data 2 | Quantity of bits | An order from high bit to low bit | Type of data | Equivalent | Data unit | Lower tolerance limit | Upper tolerance limit | ... ... |
| | ... | ... | ... | ... | ... | ... | ... | ... | ... |
| (N+1)th row in configuration file | To-be- parsed data N | Quantity of bits | An order from high bit to low bit | Type of data | Equivalent | Data unit | Lower tolerance limit | Upper tolerance limit | |

In the above two configuration files, the received data is correlated to dynamic data.

In one embodiment, a configuration file of a simple algorithm and processing such file are described as follows.

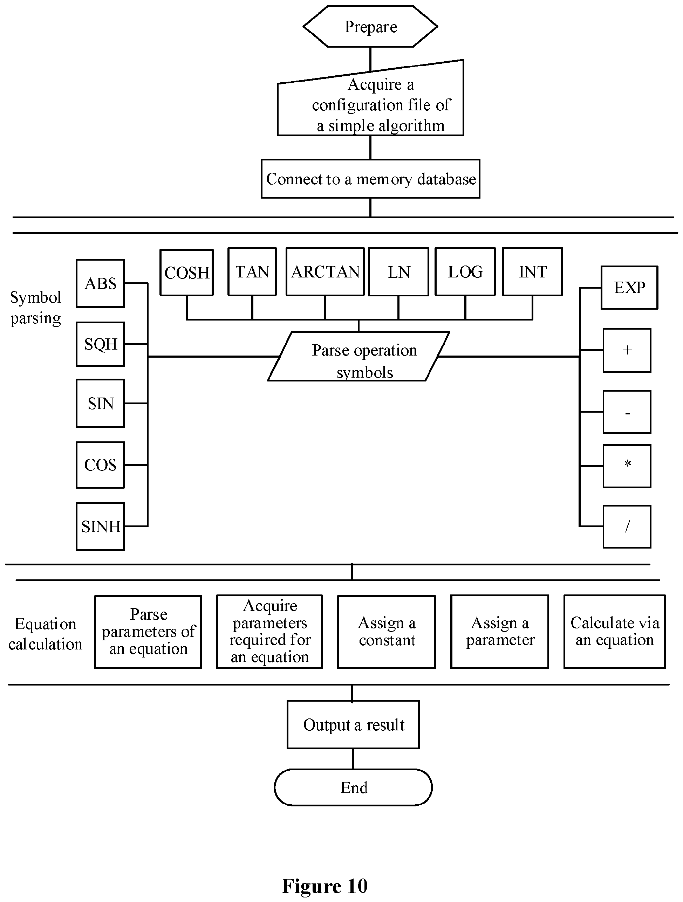

The system for intelligent data analysis and decision support in spacecraft rendezvous and docking flight control reads the configuration file of the simple algorithm, performs corresponding calculation based on variables selected from the file and rules defined in the file, adds a to-be-outputted variable to a sequence of data parsing after calculation, and stores the variable in the memory database after parsing. Operation of changing and adding a variable may be performed via an interface on requirement. After a data variable is selected and operated as required, the new variable after calculation and the selected calculation rule are generated. The variable and the rule are stored in the configuration file of the simple algorithm. The to-be-outputted variable is stored in the memory database after being parsed, and an intermediate variable is not stored. Such operations improve flexibility of data processing in the flight control is improved, which facilitates real-time comparison and processing of flight control data. An advantage is that the generated variable is based on content of a variable that has been stored in the memory database, since an interface operation does not affect underlying processing for data storage. After the configuration file for calculation is loaded, values of all newly added variables calculated during the flight control process can be acquired. The configuration file of the simple algorithm defines which variables in the real-time databases are used to calculate a variable of interest. Processing among the related variables is described a manner of symbol definition. The symbol definition for the processing is as shown in Figure 10, which is a schematic diagram of a simple algorithm according to an embodiment of the present disclosure.

Comparison of data from three machines is taken as an example for illustrating processing through the simple algorithm.

A spacecraft has a three-machine hot backup structure, that is, three on-orbit CPU (central processing unit) boards that are independent from each other run programs simultaneously. In a case that an output is greater than a value specified by the tolerance limit, it is determined that there is an abnormality in comparison processing of the three machines. In a case that the value outputted by comparison of the three machines is less than the value specified by the tolerance limit, it is determined that the three machines operate normally. A same variable outputted by the three machines during on-orbit flight are selected in an interface operation. Selected are a variable 1A, a variable 1B, and a variable 1C, which are the same variable outputted by the three machines, respectively. Differences between each pair among such three variables are calculated to configure three new variables a, b, and c. In the interface-operation, the variables a, b and c are set to be a = variable 1A - variable 1B, b = variable 1B - variable 1C, and c = variable 1A - variable 1C, that is, each is a difference between two of the three variables. Variables d and e are further added, which are a positive limit and a negative limit of tolerance for a comparison error. There is d = f and e = -f in a case that a limit of the tolerance is f. The aforementioned five variables are stored in the memory database. Variables a, b, and c are correlated to values in real-time telemetry, and vary in each cycle with the acquired real-time telemetry data. Variables d and e are constants, and are limits for data comparison. The five variables are plotted in one interface to determine whether values in curves of a, b, and c exceed an upper limit and a lower limit defined by d and e. Thereby, a current state of data processing in the three machines can be perceived quickly and intuitively.

In processing of the simple algorithm, the configuration file is generated by setting corresponding variables in the interface. The system for intelligent data analysis and decision support in spacecraft rendezvous and docking flight control in operation first acquires information from the configuration file. Custom variables are acquired form the memory database based on definition in the configuration file, and operational symbols are parsed, (the simple algorithm defines operational symbols that are commonly used, and complex operations of recursive pre-calculation matrix are addressed in a configuration file of a complex algorithm and a dynamic library. The processing of the simple algorithm defines simple operational symbols and the corresponding meanings as follows. "ABS" represents calculating an absolute value, "SQH" represents calculating a square root, "SIN" represents calculating a sine value, "COS" represents calculating a cosine value, "SINH" represents calculating an inverse sine value, "COSH" represents calculating an inverse cosine value, "TAN" represents calculating a tangent value, "ARCTAN" represents calculating a cotangent value, "LN" represents calculating a Napierian logarithm, "LOG" represents calculating a logarithm, "INT" represents keeping an integer part, "EXP" represents calculating a exponent, "+" represents performing add operation, "-" represents performing subtraction operation, "*" represents performing multiplying operation, and "/" represents performing dividing operation.

In an embodiment of the present disclosure, a configuration file of a complex algorithm, a dynamic processing library of the complex operation, and a corresponding data processing are described as follows.

A configuration file and a dynamic library of a complex algorithm for the system for intelligent data analysis and decision support in spacecraft rendezvous and docking flight control include the configuration file of the complex algorithm and the dynamic processing library of a complex operation. In such case, the complex operation is encapsulated in a unified manner, which improves maintainability of the system and facilitates expansion of functional applications. Relevant information, such as a selected variable, an outputted variable, a simulation step size of the complex operation, is defined in the configuration file. The dynamic library provides content for the corresponding data processing in the complex operation. Such encapsulation is correlated to the system for intelligent data analysis and decision support in spacecraft rendezvous and docking flight control as follows: a sequence of variables acquired from the system for intelligent data analysis and decision support in spacecraft rendezvous and docking flight control, and periodic calculation of the dynamic library, and a sequence of variables acquired from the system for intelligent data analysis and decision support in spacecraft rendezvous and docking flight control after the calculation of the dynamic library. The configuration file includes variables that are required to be acquired form the memory database. The configuration file includes an iteration period for invoking the dynamic library, a name of the corresponding dynamic library, names of variables that are required to be stored in the memory database, and corresponding formats. There are three modes of the complex operation, which a single-run mode, a cycled mode of refreshing in synchronization with real-time data, and a mode of refreshing with a preset cycle.

Trajectory forecast is taken as an example for illustrating processing of the complex algorithm.

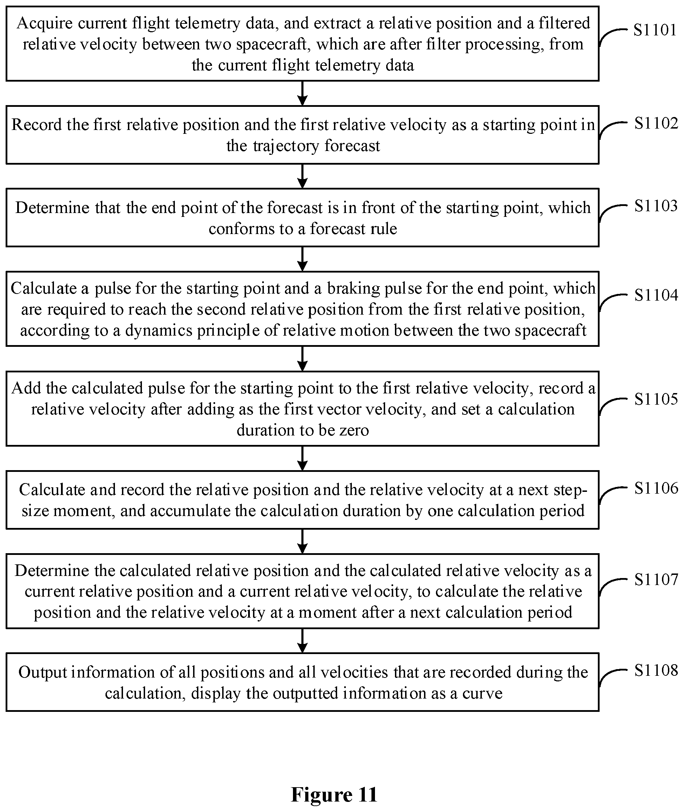

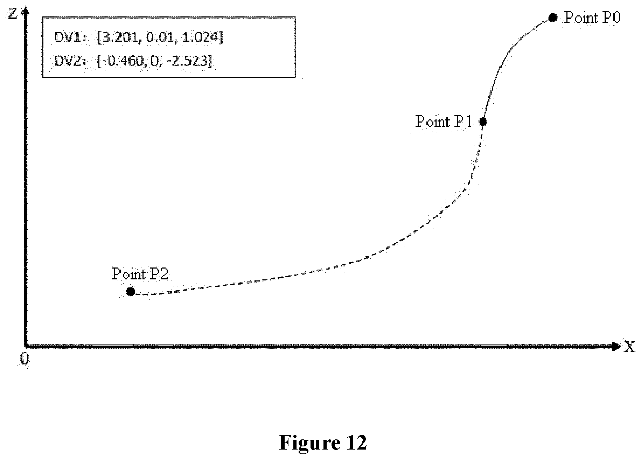

Figure 11 is a flowchart of a method for forecasting and processing a trajectory based on on-orbit data fusion according to an embodiment of the present disclosure. Figure 12 is a schematic diagram of an output curve as a result of trajectory forecast according to an embodiment of the present disclosure. The method for forecasting and processing a trajectory based on on-orbit data fusion may include following steps S1101 to S1108.

In step S1101, current flight telemetry data is acquired, and a relative position and a filtered relative velocity between two spacecraft, after filter processing, are extracted from the current flight telemetry data.

In one embodiment, after the support system for the flight control is started on the ground, the a module for real-time monitoring and pre-estimating acquires the current flight telemetry data via the module for fusing and processing multi-source data, extracts the filtered relative positions and the filtered relative velocity of the two spacecrafts from the current flight telemetry data as the first relative position and the first relative velocity, and extracts the information of an end point of a next flight phase as an end point of the trajectory forecast. A relative position and a relative velocity at the end point are recorded as the second relative position and the second relative velocity, where reference is made to point P2 in Figure 12.

In step S 1102, the first relative position and the first relative velocity are recorded as a starting point in the trajectory forecast.

In one embodiment, the first relative position and the first relative velocity are recorded as a starting point in the trajectory forecast, in a case that data in a current frame is valid, where reference is made to point P1 in Figure 12.

In step S1103, it is determined that the end point of the forecast is in front of the starting point, which conforms to a forecast rule.

In on embodiment, an X-axis position of the first relative position is compared with an X-axis position of the second relative position (an X-axis position of a relative position of the two spacecraft refers to a distance between a tracking spacecraft and a target spacecraft in the X-axis direction, where the target spacecraft serves as an origin of a coordinate system, a forward direction of the target spacecraft is a direction of the X-axis (corresponding to the X-axis in Figure 12), a direction perpendicular to a bottom of the target spacecraft is a direction of a Z-axis (corresponding to the Z-axis in Figure 12), and a Y axis is determined according to the right-hand rule). The end point of the forecast is considered to be in front of the starting point, which conforms to the forecast rule, in a case that a distance on the X-axis position of the second relative position is smaller than that of the first relative position. Then, the method goes to a next step.

In step S1104, a pulse for the starting point and a braking pulse for the end point, which are required to reach the second relative position from the first relative position, are calculated according to a dynamics principle of relative motion between the two spacecraft.

In one embodiment, the pulse for the starting point and the braking pulse for the end point, which are required to reach the second relative position from the first relative position, are calculated according to the dynamics principle of relative motion between the two spacecraft, and are recorded as DV1 and DV2, respectively.

In step S 1105, the calculated pulse for the starting point is added to the first relative velocity, and a relative velocity after adding is recorded as the first vector velocity, and a calculation duration is set to be zero.

In step S 1106, the relative position and the relative velocity at a next step-size moment are calculated and recorded, the calculation duration is accumulated by one calculation period.

In one embodiment, the first relative position and the first vector velocity serve as initial states for calculating the relative position and the relative velocity at the next step-size moment. The relative position and the relative velocity at the next step-size moment are recorded, and the calculation duration is accumulated by one calculation period.

In step S 1107, the calculated relative position and the calculated relative velocity serve as a current relative position and a current relative velocity, to calculate the relative position and the relative velocity at a moment after a next calculation period.

In one embodiment, the calculated relative position and the calculated relative velocity serve as the current relative position and the current relative velocity, to calculate the relative position and the relative velocity at the moment after the next calculation period. The relative position and the relative velocity at the moment after the next calculation period are recorded. The calculation duration is accumulated by one calculation period. This step is repeated until the total calculation duration reaches an overall duration for the forecast.

In step S1108, information of all positions and all velocities that are recorded during the calculation is outputted and displayed as a curve.

In one embodiment, information of all positions and all velocities that are recorded during the calculation is outputted and displayed as the curve, as indicated by a dotted line between the point P1 and the point P2 in Figure 12. A solid line between point P0 and the point P1 represents a real on-orbit flight trajectory. Values of DV1 and DV2 are outputted, as shown in Figure 12 (the three values correspond to directions of three coordinate axes described in the step 1103), for monitor and decision making of ground personnel of the flight control to monitor and make decisions.

In summary, the system for intelligent data analysis and decision support in spacecraft rendezvous and docking flight control is provided. The real-time data, the simulation calculation, and the target-machine verification data of a flight mission are stored in a complete, high-efficient and expansible manner for the flight control mission. On such basis, data of a variable of interest (including history data at any moment and real-time data) can be acquired quickly and accurately. Addressed is a problem in a conventional flight control environment that mathematical simulation calculation and target-machine verification cannot be quickly performed based on orbit data at a certain moment since acquisition of data is tedious and slow. A period for acquiring data of a specified variable at any moment is reduced from more than 3 minutes to 2 seconds in average, thereby improving a performance by nearly 100 times.

Further, the multi-source heterogeneous data, such as the real-time on-orbit data, the data of simulation and comparison, and the target-machine verification data, can be efficiently fused in the flight control mission for the spacecraft. For the first time, a capability for pre-estimating and forecasting the flight state is flexible, fast, and accurate. Significantly improved are capabilities for comparing and analyzing data that is monitored in real time, and for positioning and analyzing an on-orbit fault quickly.

The embodiments of the present disclosure are described in a progressive manner, and each embodiment places emphasis on the difference from other embodiments. Therefore, one embodiment can refer to other embodiments for the same or similar parts.

Described above are only preferred embodiments of the present disclosure, and the protection scope of the present disclosure is not limited thereto. The scope of the invention is defined by the appended claims.

Content not described in detail in the present disclosure is well known to those skilled in the art.

## Claims

1. A system for intelligent data analysis and decision support in spacecraft rendezvous and docking flight control, comprising:
a module (101) for acquiring and processing real-time data in flight control, configured to:
acquire original telemetry data information of a space-based station and a ground-based station from a flight control center, and
acquire information of a desired telemetry source packet from a plurality of time-sequenced data packets by extracting according to a set rule, wherein the time-sequenced data packets are from a plurality of non-homologous stations;
a module (102) for simulation and verification in flight control, configured to:
acquire an initial conditional value for simulation and verification from a module (103) for fusing and processing multi-source data;
perform flight-control-scheme simulation and verification operation to obtain simulation and verification data for the flight control scheme;
perform control-software simulation and verification operation to obtain simulation and verification data for the control software;
perform target-machine physical verification to obtain verification result data for the target machine; and
transmit the simulation and verification data for the flight control scheme, the simulation and verification data for the control software and the verification result data for the target machine to the module (103) for fusing and processing multi-source data;
the module (103) for fusing and processing multi-source data, configured to:
parse automatically real-time flight control data, the simulation and verification data for the flight control scheme, the simulation and verification data for the control software, the verification result data for the target machine, and flight data of history rendezvous and docking missions that are transmitted to the module (103) for fusing and processing multi-source data, and
store the parsed data in a module (104) for memory-database processing;
the module (104) for memory-database processing, configured to solidify the parsed data to a hard disk at each set time interval, via a hardware interface;
a module (105) for intelligent analysis in flight control, configured to:
monitor and analyze the real-time flight control data, the simulation and verification data for the flight control scheme, and the simulation and verification data for the control software that are acquired from the module (103) for fusing and processing multi-source data, and
pre-estimate and forecast a trajectory curve; and
a module (106) for decision support in flight control, configured to perform a support operation for a flight control decision by interpreting a condition and a state, based on data that are transmitted from the module (101) for acquiring and processing real-time data in flight control, the module (102) for simulation and verification in flight control, and the module (105) for intelligent analysis in flight control, to the module (103) for fusing and processing multi-source data.

2. The system according to claim 1, further comprising: a module (107) for displaying curves and processing interface operations, configured to:
display multi-source heterogeneous data corresponding to the support operation as a curve,
refresh the multi-source heterogeneous data on an interface periodically or for once, to enable the multi-source heterogeneous data to be adjustable along a horizontal axis and a vertical axis, facilitating data comparison and analysis.

3. The system according to claim 1, wherein the module (101) for acquiring and processing real-time data in flight control comprises:
a sub-module for extracting complex telemetry packets, configured to:
acquire the original telemetry data information of the space-based station and the ground-based station from the flight control center, and
acquire the information of the desired telemetry source packet from the plurality of time-sequenced data packets by extracting according to a set rule, wherein the time-sequenced data packets are from the plurality of non-homologous stations; and
a sub-module for dynamically selecting stations, configured to:
perform dynamic selection of a station on the data extracted by the sub-module for extracting complex telemetry packets, based on a strategy of a unified time sequence, and
obtain data required for decision support in the flight control, through data filtering.

4. The system according to claim 1, wherein the module (102) for simulation and verification in flight control comprises:
a sub-module for simulation and verification of flight control schemes, configured to:
perform simulation and verification for the flight control scheme, with on-orbit data of the flight control obtained from the module (103) for fusing and processing multi-source data as an initial condition, to obtain the simulation and verification data for the flight control scheme;
analyze the simulation and verification data for the flight control scheme, or transmit the simulation and verification data for the flight control scheme to the module (103) for fusing and processing multi-source data for comparison with the real-time flight control data;
wherein the simulation and verification for the flight control scheme comprises verifying in advance a critical function for safety of the flight control, Monte Carlo experiment and bias test;
a sub-module for simulation and verification of control software, configured to:
perform, for a flight mission, quick verification on software of a software simulation platform for the flight control, with the on-orbit data of the flight control obtained from the module (103) for fusing and processing multi-source data as an initial condition, to obtain an operation state of the software under a corresponding condition as the simulation and verification data for the control software; and
transmit the simulation and verification data for the control software to the module (103) for fusing and processing multi-source data, for comparison with the real-time flight control data; and
a sub-module for target-machine physical verification, configured to:
test and verify the flight mission, with the on-orbit data of the flight control obtained from the module (103) for fusing and processing multi-source data as an initial condition, to obtain verification result data for the target machine; and
analyze the verification result data for the target machine, or transmit the verification result data for the target machine to the module (103) for fusing and processing multi-source data for comparison with the real-time flight control data.

5. The system according to claim 1, wherein the module (103) for fusing and processing multi-source data comprises:
a sub-module for fusing multi-source data, configured to:
parse automatically the real-time flight control data, the simulation and verification data for the flight control scheme, the simulation and verification data for the control software, the verification result data for the target machine, and the flight data of history rendezvous and docking missions; and
store the parsed data in the module (104) for memory-database processing;
a sub-module for data acquisition, configured to:
read feature information of a predefined configuration file, and
acquire independent data of a corresponding variable at a specified moment, or acquire an array of data of the corresponding variable within a continuous period;
a sub-module for dynamic setting, configured to:
generate a new variable required in the flight control mission, by operating on an interface or linking to a dynamic library;
generate a configuration file based on the new variable required in the flight control mission; and
load configuration information in the configuration file dynamically to a storage sequence; and
a sub-module for history flight data, configured to:
store a typical process and typical state data of the flight control; and
provide basic data for comparison in data processing of the module (105) for intelligent analysis in flight control.

6. The system according to claim 1, wherein the module (105) for intelligent analysis in flight control comprises:
a sub-module for monitoring real-time states, configured to:
monitor information of a real-time flight state, and
obtain real-time data of a key data variable in the flight control, wherein the real-time data of the key data variable in the flight control comprises orbit information, attitude information, sensor state information, sensor measurement information, and actuator data;
a sub-module for interpreting intelligent data, configured to:
perform intelligent data analysis based on states of simulation data, history data, and real-time flight data, and
provide support data for interpretation in the support operation for the flight control decision; and
a sub-module for forecasting flight states, configured to pre-estimate and forecast the trajectory curve, with real-time on-orbit flight data as an initial condition, to obtain a forecast result for a state of the flight control before a key event and provide decision support for determination in advance in a flight control mission.

7. The system according to claim 1, wherein the module (105) for intelligent analysis in flight control is further configured to:
provide a standardized interface, via which an external plugin exchanges data with the module (105) for intelligent analysis in flight control.

8. The system according to claim 1, wherein the module (106) for decision support in flight control comprises:
a sub-module for automatic decision processing in normal flight control procedure, configured to:
extract, based on the flight mission, data required in the flight mission from the module (103) for fusing and processing multi-source data;
generate uplink injection data based on the extracted data required in the flight mission;
determine the data required in the flight mission and the uplink injection data as input data, and trigger the module (102) for simulation and verification in flight control to simulate and verify the uplink injection data, to obtain a result of simulation and verification;
upload the uplink injection data that is verified to the spacecraft, via the module (103) for fusing and processing multi-source data that acquires the result of simulation and verification outputted by the module (102) for simulation and verification in flight control;
acquire an operating result of the spacecraft, which is based on the uplink injection data that is verified;
verify again, based on the operating result, the uplink injection data that is verified;
wherein the result of simulation and verification that is outputted by the module (102) for simulation and verification in flight control and acquired by the module (103) for fusing and processing multi-source data comprises: the uplink injection data that is verified through the simulation and verification; and
wherein the data required in the flight mission comprises spacecraft attitude information, orbit information, and health information of an operation state;
a sub-module for safety pre-warning processing, configured to:
acquire safety state information of the spacecraft, safety corridor information of an orbit, and health state information of a sensor actuator, from the module (103) for fusing and processing multi-source data;
compare the safety state information of the spacecraft, the safety corridor information of the orbit, and the health state information of the sensor actuator with thresholds, respectively; and
perform safety pre-warning based on a result of the comparing; and
a sub-module for fault emergency processing, configured to:
acquire information of a sudden emergency fault during the flight mission, from the module (103) for fusing and processing multi-source data;
select a contingency plan for the sudden emergency fault, wherein the contingency plan matches the information of the sudden emergency fault;
determine whether the sudden emergency fault is eliminated after executing the sudden emergency fault contingency plan; and
trigger the sub-module for safety pre-warning processing, in a case that the sudden emergency fault is eliminated.

9. The system according to claim 2, wherein the module (107) for displaying curves and processing interface operations comprises:
a sub-module for display curves, configured to refresh, periodically or for once, the multi-source heterogeneous data corresponding to the support operation for the flight control decision on the interface, to enable the multi-source heterogeneous data to be adjustable along a horizontal axis and a vertical axis, facilitating data comparison and analysis and providing a scene of visual display for data processing; and
a sub-module for interface operations, configured to provide a function option for managing a configuration file, a function option for storing data, a function option for extracting data, a function option for displaying a curve, a function option for data calculation, and a function option for linking to a dynamic processing library.

## Patentansprüche

1. System zur intelligenten Datenanalyse und Entscheidungsunterstützung bei der Rendezvous- und Andockflugsteuerung von Raumfahrzeugen, umfassend:
ein Modul (101) zur Erfassung und Verarbeitung von Echtzeitdaten in der Flugsteuerung, das dazu konfiguriert ist:
ursprüngliche Telemetriedateninformationen einer weltraumgestützten Station und einer bodengestützten Station von einem Flugkontrollzentrum zu erhalten, und Informationen eines gewünschten Telemetrie-Quellpakets aus einer Vielzahl zeitlich aufeinanderfolgender Datenpakete durch Extrahieren gemäß einer festgelegten Regel zu erfassen, wobei die zeitlich sequenzierten Datenpakete von mehreren nicht homologen Stationen stammen;
ein Modul (102) zur Simulation und Verifizierung in der Flugsteuerung, das dazu konfiguriert ist:
einen anfänglichen bedingten Wert für die Simulation und Verifizierung von einem Modul (103) zum Zusammenführen und Verarbeiten von Daten aus mehreren Quellen zu erhalten;
einen Flugsteuerungssimulations- und Verifizierungsvorgang durchzuführen, um Simulations- und Verifizierungsdaten für das Flugsteuerungsschema zu erhalten;
einen Steuerungssoftware-Simulations- und Verifizierungsvorgang durchzuführen, um Simulations-und Verifizierungsdaten für die Steuerungssoftware zu erhalten;
eine physische Verifizierung der Zielmaschine durchzuführen, um Verifizierungsergebnisdaten für die Zielmaschine zu erhalten; und
die Simulations- und Verifizierungsdaten für das Flugsteuerungsschema, die Simulations- und Verifizierungsdaten für die Steuerungssoftware und die Verifizierungsergebnisdaten für die Zielmaschine an das Modul (103) zum Zusammenführen und Verarbeiten von Daten aus mehreren Quellen zu übertragen;
das Modul (103) zum Zusammenführen und Verarbeiten von Daten aus mehreren Quellen, das dazu konfiguriert ist:
automatisch Echtzeit-Flugsteuerungsdaten, die Simulations- und Verifizierungsdaten für das Flugsteuerungsschema, die Simulations- und Verifizierungsdaten für die Steuerungssoftware, die Verifizierungsergebnisdaten für die Zielmaschine und Flugdaten von historischen Rendezvous- und Andockmissionen zu analysieren, die an das Modul (103) zur Zusammenführung und Verarbeitung von Multi-Source-Daten übermittelt werden, und
die analysierten Daten in einem Modul (104) zur Speicher-Datenbank-Verarbeitung zu speichern;
das Modul (104) für die Speicher-Datenbank-Verarbeitung, das dazu konfiguriert ist, die analysierten Daten in jedem festgelegten Zeitintervall über eine Hardware-Schnittstelle auf einer Festplatte zu verfestigen;
ein Modul (105) zur intelligenten Analyse in der Flugsteuerung, das dazu konfiguriert ist:
die Echtzeit-Flugsteuerungsdaten, die Simulations- und Verifizierungsdaten für das Flugsteuerungsschema und die Simulations- und Verifizierungsdaten für die Steuerungssoftware zu überwachen und zu analysieren, die vom Modul (103) zum Zusammenführen und Verarbeiten von Daten aus mehreren Quellen erfasst werden, und
eine Flugbahnkurve vorab abzuschätzen und vorherzusagen; und
ein Modul (106) zur Entscheidungsunterstützung in der Flugsteuerung, das dazu konfiguriert ist, einen Unterstützungsvorgang für eine Flugsteuerungsentscheidung durch Interpretation einer Bedingung und eines Zustands basierend auf Daten, die vom Modul (101) zur Erfassung und Verarbeitung von Echtzeitdaten in der Flugsteuerung, dem Modul (102) zur Simulation und Verifizierung in der Flugsteuerung und dem Modul (105) zur intelligenten Analyse in der Flugsteuerung an das Modul (103) zur Zusammenführung und Verarbeitung von Multi-Source-Daten übermittelt werden, durchzuführen.

2. System nach Anspruch 1, weiterhin umfassend: ein Modul (107) zum Anzeigen von Kurven und Verarbeiten von Schnittstellenvorgängen, das dazu konfiguriert ist:
heterogene Daten aus mehreren Quellen, die dem Supportvorgang entsprechen, als Kurve anzuzeigen,
die heterogenen Multi-Source-Daten auf einer Schnittstelle regelmäßig oder einmalig zu aktualisieren, um die Anpassung der heterogenen Daten aus mehreren Quellen entlang einer horizontalen und einer vertikalen Achse zu ermöglichen, was den Datenvergleich und die Datenanalyse erleichtert.

3. System nach Anspruch 1, wobei das Modul (101) zur Erfassung und Verarbeitung von Echtzeitdaten in der Flugsteuerung Folgendes umfasst:
ein Untermodul zum Extrahieren komplexer Telemetriepakete, das dazu konfiguriert ist:
die ursprünglichen Telemetriedateninformationen der weltraumgestützten Station und der bodengestützten Station vom Flugkontrollzentrum zu erhalten, und
die Informationen des gewünschten Telemetrie-Quellpakets aus der Vielzahl zeitlich sequentieller Datenpakete durch Extrahieren gemäß einer festgelegten Regel zu erfassen, wobei die zeitlich sequenzierten Datenpakete von mehreren nicht homologen Stationen stammen; und
ein Untermodul zur dynamischen Auswahl von Stationen, das dazu konfiguriert ist:
eine dynamische Auswahl einer Station anhand der vom Untermodul zum Extrahieren komplexer Telemetriepakete extrahierten Daten basierend auf einer Strategie einer einheitlichen Zeitsequenz durchzuführen, und
durch Datenfilterung Daten zu gewinnen, die zur Entscheidungsunterstützung in der Flugsteuerung erforderlich sind.

4. System nach Anspruch 1, wobei das Modul (102) zur Simulation und Verifikation in der Flugsteuerung Folgendes umfasst:
ein Untermodul zur Simulation und Verifizierung von Flugsteuerungsschemata, das dazu konfiguriert ist:
eine Simulation und Verifizierung für das Flugsteuerungsschema mit vom Modul (103) erhaltenen On-Orbit-Daten der Flugsteuerung zum Zusammenführen und Verarbeiten von Daten aus mehreren Quellen als Ausgangsbedingung durchzuführen, um die Simulations-und Verifizierungsdaten für das Flugsteuerungsschema zu erhalten;
die Simulations- und Verifizierungsdaten für das Flugsteuerungsschema zu analysieren oder die Simulations- und Verifizierungsdaten für das Flugsteuerungsschema an das Modul (103) zu übertragen, um Daten aus mehreren Quellen zum Vergleich mit den Echtzeit-Flugsteuerungsdaten zu fusionieren und zu verarbeiten;
wobei die Simulation und Verifizierung für das Flugsteuerungsschema die vorherige Verifizierung einer kritischen Funktion für die Sicherheit der Flugsteuerung, ein Monte-Carlo-Experiment und einen Bias-Test umfasst;
ein Untermodul zur Simulation und Verifizierung von Steuerungssoftware, das dazu konfiguriert ist:
für eine Flugmission eine schnelle Verifizierung auf Software einer Softwaresimulationsplattform für die Flugsteuerung mit den vom Modul (103) erhaltenen On-Orbit-Daten der Flugsteuerung zur Fusionierung und
Verarbeitung von Daten aus mehreren Quellen als Ausgangsbasis Zustand durchzuführen, um einen Betriebszustand der Software unter einer entsprechenden Bedingung als Simulations- und Verifizierungsdaten für die Steuersoftware zu erhalten; und
die Simulations- und Verifizierungsdaten für die Steuerungssoftware an das Modul (103) zu übertragen, um Daten aus mehreren Quellen zusammenzuführen und zu verarbeiten und mit den Echtzeit-Flugsteuerungsdaten zu vergleichen; und
ein Untermodul für die physische Verifizierung der Zielmaschine, das dazu konfiguriert ist:
die Flugmission zu testen und zu verifizieren, wobei die vom Modul (103) erhaltenen On-Orbit-Daten der Flugsteuerung zur Fusionierung und Verarbeitung von Multi-Source-Daten als Ausgangsbedingung dienen, um Verifizierungsergebnisdaten für die Zielmaschine zu erhalten; und
die Verifizierungsergebnisdaten für die Zielmaschine zu analysieren oder die Verifizierungsergebnisdaten für die Zielmaschine an das Modul (103) zu übertragen, um Daten aus mehreren Quellen für den Vergleich mit den Echtzeit-Flugsteuerungsdaten zu fusionieren und zu verarbeiten.

5. System nach Anspruch 1, wobei das Modul (103) zum Zusammenführen und Verarbeiten von Multi-Source-Daten Folgendes umfasst:
ein Untermodul zum Zusammenführen von Daten aus mehreren Quellen, das dazu konfiguriert ist:
die Echtzeit-Flugsteuerungsdaten, die Simulations- und Verifizierungsdaten für das Flugsteuerungsschema, die Simulations- und Verifizierungsdaten für die Steuerungssoftware und die Verifizierungsergebnisdaten für die Zielmaschine und die Flugdaten historischer Rendezvous- und Andockmissionen automatisch zu analysieren; und
die analysierten Daten im Modul (104) zur Speicher-Datenbank-Verarbeitung zu speichern;
ein Untermodul zur Datenerfassung, das dazu konfiguriert ist:
Funktionsinformationen einer vordefinierten Konfigurationsdatei zu lesen und
unabhängige Daten einer entsprechenden Variablen zu einem bestimmten Zeitpunkt zu erfassen oder eine Reihe von Daten der entsprechenden Variablen innerhalb eines kontinuierlichen Zeitraums zu erfassen;
ein Untermodul für dynamische Einstellungen, das dazu konfiguriert ist:
eine neue Variable, die für die Flugsteuerungsmission erforderlich ist, durch Betrieb an einer Schnittstelle oder durch Verknüpfung mit einer dynamischen Bibliothek zu erzeugen;
eine Konfigurationsdatei basierend auf der neuen Variablen zu erzeugen, die in der Flugsteuerungsmission erforderlich ist; und
Konfigurationsinformationen in der Konfigurationsdatei dynamisch in eine Speichersequenz zu laden; und
ein Untermodul für historische Flugdaten, das dazu konfiguriert ist:
einen typischen Ablauf und typische Zustandsdaten der Flugsteuerung zu speichern; und
Basisdaten zum Vergleich in der Datenverarbeitung des Moduls (105) zur intelligenten Analyse in der Flugsteuerung bereitzustellen.

6. System nach Anspruch 1, wobei das Modul (105) zur intelligenten Analyse in der Flugsteuerung Folgendes umfasst:
ein Untermodul zur Überwachung von Echtzeitzuständen, das dazu konfiguriert ist:
Informationen über einen Flugzustand in Echtzeit zu überwachen und
Echtzeitdaten einer Schlüsseldatenvariable in der Flugsteuerung zu erhalten, wobei die Echtzeitdaten der Schlüsseldatenvariablen in der Flugsteuerung Umlaufbahninformationen, Lageinformationen, Sensorzustandsinformationen, Sensormessinformationen und Aktuatordaten umfassen;
ein Untermodul zur Interpretation intelligenter Daten, das dazu konfiguriert ist:
eine intelligente Datenanalyse basierend auf den Zuständen von Simulationsdaten, Verlaufsdaten und Echtzeit-Flugdaten durchzuführen, und
Unterstützungsdaten zur Interpretation im Unterstützungsbetrieb für die Flugsteuerungsentscheidung bereitzustellen; und
ein Untermodul zur Vorhersage von Flugzuständen, das dazu konfiguriert ist, die Flugbahnkurve mit Echtzeit-Flugdaten im Orbit als Ausgangsbedingung vorab abzuschätzen und vorherzusagen, um ein Prognoseergebnis für einen Zustand der Flugsteuerung vor einem Schlüsselereignis zu erhalten und Entscheidungsunterstützung für die Bestimmung im Vorfeld einer Flugsteuerungsmission bereitzustellen.

7. System nach Anspruch 1, wobei das Modul (105) zur intelligenten Analyse in der Flugsteuerung weiterhin dazu konfiguriert ist:
eine standardisierte Schnittstelle bereitzustellen, über die ein externes Plugin Daten mit dem Modul (105) zur intelligenten Analyse in der Flugsteuerung austauscht.

8. System nach Anspruch 1, wobei das Modul (106) zur Entscheidungsunterstützung in der Flugsteuerung Folgendes umfasst:
ein Untermodul für die automatische Entscheidungsverarbeitung im normalen Flugsteuerungsverfahren, das dazu konfiguriert ist:
basierend auf der Flugmission, in der Flugmission benötigte Daten aus dem Modul (103) zur Zusammenführung und Verarbeitung von Multi-Source-Daten zu extrahieren;
Uplink-Injection-Daten basierend auf den extrahierten Daten zu erzeugen, die für die Flugmission erforderlich sind;
die im Flugeinsatz benötigten Daten und die Uplink-Injektionsdaten als Eingangsdaten zu ermitteln und um das Modul (102) zur Simulation und Verifizierung in der Flugsteuerung auszulösen, um die Uplink-Injektionsdaten zu simulieren und zu verifizieren, um ein Ergebnis der Simulation und Verifizierung zu erhalten;
die verifizierten Uplink-Injection-Daten über das Modul (103) zum Zusammenführen und Verarbeiten von Multi-Source-Daten zum Raumfahrzeug hochzuladen, das das vom Modul (102) ausgegebene Simulations- und
Verifizierungsergebnis zur Simulation und Verifizierung in der Flugsteuerung erfasst;
ein Betriebsergebnis des Raumfahrzeugs zu erfassen, das auf den verifizierten Uplink-Injektionsdaten basiert;
die verifizierten Uplink-Injection-Daten auf der Grundlage des Betriebsergebnisses erneut zu verifizieren;
wobei das Ergebnis der Simulation und Verifizierung, das vom Modul (102) zur Simulation und Verifizierung in der Flugsteuerung ausgegeben und vom Modul (103) zur Fusion und Verarbeitung von Multi-Source-Daten erfasst wird, Folgendes umfasst: die Uplink-Injection-Daten, die durch Simulation und Verifizierung verifiziert werden; und
wobei die in der Flugmission erforderlichen Daten Informationen zur Fluglage des Raumfahrzeugs, Informationen zur Umlaufbahn und Gesundheitsinformationen eines Betriebszustands umfassen;
ein Untermodul für die Verarbeitung von Sicherheitsvorwarnungen, das dazu konfiguriert ist:
Sicherheitszustandsinformationen des Raumfahrzeugs, Sicherheitskorridorinformationen einer Umlaufbahn und Gesundheitszustandsinformationen eines Sensoraktuators vom Modul (103) zu erfassen, um Daten aus mehreren Quellen zusammenzuführen und zu verarbeiten;
die Sicherheitszustandsinformationen des Raumfahrzeugs, die Sicherheitskorridorinformationen der Umlaufbahn und die Gesundheitszustandsinformationen des Sensoraktuators jeweils mit Schwellenwerten zu vergleichen; und
eine Sicherheitsvorwarnung basierend auf einem Ergebnis des Vergleichs durchzuführen; und
ein Untermodul für die Fehler-Notfallverarbeitung, das dazu konfiguriert ist:
Informationen über einen plötzlichen Notfallfehler während der Flugmission vom Modul (103) zum Zusammenführen und Verarbeiten von Daten aus mehreren Quellen zu erhalten;
einen Notfallplan für den plötzlichen Notfallfehler auszuwählen, wobei der Notfallplan mit den Informationen des plötzlichen Notfallfehlers übereinstimmt;
zu bestimmen, ob der plötzliche Notfallfehler nach Ausführung des Notfallplans für plötzlichen Notfallfehler behoben ist; und
das Submodul zur Verarbeitung der Sicherheitsvorwarnung auszulösen, falls der plötzliche Notfallfehler behoben ist.

9. System nach Anspruch 2, wobei das Modul (107) zur Darstellung von Kurven und zur Verarbeitung von Schnittstellenvorgängen umfasst:
ein Untermodul zur Darstellung von Kurven, das dazu konfiguriert ist, die heterogenen Daten aus mehreren Quellen, die dem Unterstützungsvorgang für die Flugsteuerungsentscheidung entsprechen, regelmäßig oder einmalig auf der Schnittstelle zu aktualisieren, um die Anpassung der heterogenen Daten aus mehreren Quellen entlang einer horizontalen und einer vertikalen Achse zu ermöglichen, was den Datenvergleich und die Datenanalyse erleichtert und eine visuelle Anzeige für die Datenverarbeitung bietet; und
ein Untermodul für Schnittstellenoperationen, das dazu konfiguriert ist, eine Funktionsoption zur Verwaltung einer Konfigurationsdatei, eine Funktionsoption zur Speicherung von Daten, eine Funktionsoption zum Extrahieren von Daten, eine Funktionsoption zum Anzeigen einer Kurve, eine Funktionsoption zur Datenberechnung und eine Funktionsoption zur Verknüpfung mit einer dynamischen Verarbeitungsbibliothek bereitzustellen.

## Revendications

1. Système d'analyse de données intelligente et d'aide à la décision dans une commande de rendez-vous spatial et de vol d'amarrage, comprenant :
un module (101) d'acquisition et de traitement de données en temps réel dans une commande de vol, configuré pour :
acquérir des informations de données de télémétrie originales d'une station spatiale et d'une station au sol à partir d'un centre de commande de vol, et
acquérir des informations d'un paquet source de télémétrie souhaité à partir d'une pluralité de paquets de données séquencées dans le temps par extraction selon une règle définie, dans lequel les paquets de données séquencées dans le temps proviennent d'une pluralité de stations non homologues ;
un module (102) de simulation et de vérification dans une commande de vol, configuré pour:
acquérir une valeur conditionnelle initiale pour simulation et vérification à partir d'un module (103) de fusion et de traitement de données multi-sources ;
exécuter une opération de simulation et de vérification de schéma de commande de vol pour obtenir des données de simulation et de vérification pour le schéma de commande de vol ;
exécuter une opération de simulation et de vérification de logiciel de commande pour obtenir des données de simulation et de vérification pour le logiciel de commande ;
exécuter une vérification physique de machine cible pour obtenir des données de résultat de vérification pour la machine cible ; et
transmettre les données de simulation et de vérification pour le schéma de commande de vol, les données de simulation et de vérification pour le logiciel de commande et les données de résultat de vérification pour la machine cible au module (103) de fusion et de traitement de données multi-sources ;
le module (103) de fusion et de traitement de données multi-sources, configuré pour :
analyser automatiquement les données de commande de vol en temps réel, les données de simulation et de vérification pour le schéma de commande de vol, les données de simulation et de vérification pour le logiciel de commande, les données de résultat de vérification pour la machine cible et les données de vol de missions historiques de rendez-vous et d'amarrage qui sont transmises au module (103) de fusion et de traitement de données multi-sources, et
stocker les données analysées dans un module (104) de traitement de base de données de mémoire ;
le module (104) de traitement de base de données de mémoire, configuré pour solidifier les données analysées sur un disque dur à chaque intervalle de temps défini, via une interface matérielle ;
un module (105) d'analyse intelligente dans une commande de vol, configuré pour :
surveiller et analyser les données de commande de vol en temps réel, les données de simulation et de vérification pour le schéma de commande de vol et les données de simulation et de vérification pour le logiciel de commande qui sont acquises à partir du module (103) de fusion et de traitement de données multi-sources, et
pré-estimer et prévoir une courbe de trajectoire ; et
un module (106) d'aide à la décision dans une commande de vol, configuré pour exécuter une opération d'aide pour une décision de commande de vol en interprétant une condition et un état, sur la base de données qui sont transmises à partir du module (101) d'acquisition et de traitement en temps réel de données dans une commande de vol, du module (102) de simulation et de vérification dans une commande de vol et du module (105) d'analyse intelligente dans une commande de vol, au module (103) de fusion et de traitement de données multi-sources.

2. Système selon la revendication 1, comprenant en outre : un module (107) d'affichage de courbes et de traitement d'opérations d'interface, configuré pour :
afficher des données hétérogènes multi-sources correspondant à l'opération d'aide sous forme de courbe,
actualiser les données hétérogènes multi-sources sur une interface périodiquement ou pour une fois, pour permettre aux données hétérogènes multi-sources d'être réglables le long d'un axe horizontal et d'un axe vertical, facilitant ainsi la comparaison et l'analyse de données.

3. Système selon la revendication 1, dans lequel le module (101) d'acquisition et de traitement de données en temps réel dans une commande de vol comprend :
un sous-module d'extraction de paquets de télémétrie complexes, configuré pour :
acquérir les informations de données de télémétrie originales de la station spatiale et de la station au sol à partir du centre de commande de vol, et
acquérir les informations du paquet source de télémétrie souhaité à partir de la pluralité de paquets de données séquencées dans le temps par extraction selon une règle définie, dans lequel les paquets de données séquencées dans le temps proviennent de la pluralité de stations non homologues ; et
un sous-module de sélection dynamique de stations, configuré pour :
exécuter une sélection dynamique d'une station sur les données extraites par le sous-module d'extraction de paquets de télémétrie complexes, sur la base d'une stratégie d'une séquence temporelle unifiée, et
obtenir des données nécessaires à l'aide à la décision dans dans la commande de vol, à travers un filtrage de données.

4. Système selon la revendication 1, dans lequel le module (102) de simulation et de vérification dans une commande de vol comprend :
un sous-module de simulation et de vérification de schémas de commande de vol, configuré pour :
exécuter une simulation et une vérification pour le schéma de commande de vol, avec des données en orbite de la commande de vol obtenues à partir du module (103) de fusion et de traitement de données multi-sources en tant que condition initiale, pour obtenir les données de simulation et de vérification pour le schéma de commande de vol ;
analyser les données de simulation et de vérification pour le schéma de commande de vol, ou transmettre les données de simulation et de vérification pour le schéma de commande de vol au module (103) de fusion et de traitement de données multi-sources pour comparaison avec les données de commande de vol en temps réel ;
dans lequel la simulation et la vérification pour le schéma de commande de vol comprennent la vérification à l'avance d'une fonction critique pour la sécurité de la commande de vol, une expérience de Monte Carlo et une évaluation des biais ;
un sous-module de simulation et de vérification de logiciel de commande, configuré pour :
exécuter, pour une mission de vol, une vérification rapide sur logiciel d'une plateforme de simulation logicielle pour la commande de vol, avec les données en orbite de la commande de vol obtenues à partir du module (103) de fusion et de traitement de données multi-sources en tant que condition initiale, pour obtenir un état de fonctionnement du logiciel dans une condition correspondante en tant que données de simulation et de vérification pour le logiciel de commande ; et
transmettre les données de simulation et de vérification pour le logiciel de commande au module (103) de fusion et de traitement de données multi-sources, pour comparaison avec les données de commande de vol en temps réel ; et
un sous-module de vérification physique de machine cible, configuré pour :
tester et vérifier la mission de vol, avec les données en orbite de la commande de vol obtenues à partir du module (103) de fusion et de traitement de données multi-sources en tant que condition initiale, pour obtenir des données de résultat de vérification pour la machine cible ; et
analyser les données de résultat de vérification pour la machine cible, ou transmettre les données de résultat de vérification pour la machine cible au module (103) de fusion et de traitement de données multi-sources pour comparaison avec les données de commande de vol en temps réel.

5. Système selon la revendication 1, dans lequel le module (103) de fusion et de traitement de données multi-sources comprend :
un sous-module de fusion de données multi-sources, configuré pour :
analyser automatiquement les données de commande de vol en temps réel, les données de simulation et de vérification pour le schéma de commande de vol, les données de simulation et de vérification pour le logiciel de commande, les données de résultat de vérification pour la machine cible et les données de vol de missions historiques de rendez-vous et d'amarrage ; et
stocker les données analysées dans le module (104) de traitement de base de données de mémoire ;
un sous-module d'acquisition de données, configuré pour :
lire des informations de caractéristiques d'un fichier de configuration prédéfini, et
acquérir des données indépendantes d'une variable correspondante à un moment spécifié, ou acquérir un tableau de données de la variable correspondante au cours d'une période continue ;
un sous-module de paramétrage dynamique, configuré pour :
générer une nouvelle variable nécessaire à la mission de commande de vol, en opérant sur une interface ou en se liant à une bibliothèque dynamique ;
générer un fichier de configuration sur la base de la nouvelle variable requise dans la mission de commande de vol ; et
charger dynamiquement des informations de configuration dans le fichier de configuration dans une séquence de stockage ; et
un sous-module de données de vol historiques, configuré pour :
stocker un processus typique et des données d'état typiques de la commande de vol ; et
fournir des données de base à des fins de comparaison dans un traitement de données du module (105) d'analyse intelligente dans une commande de vol.

6. Système selon la revendication 1, dans lequel le module (105) d'analyse intelligente dans une commande de vol comprend :
un sous-module de surveillance d'états en temps réel, configuré pour :
surveiller des informations d'un état de vol en temps réel, et
obtenir des données en temps réel d'une variable de données clés dans la commande de vol, dans lequel les données en temps réel de la variable de données clés dans la commande de vol comprennent des informations d'orbite, des informations d'attitude, des informations d'état de capteur, des informations de mesure de capteur et des données d'actionneur ;
un sous-module d'interprétation de données intelligentes, configuré pour :
exécuter une analyse de données intelligente sur la base d'états de données de simulation, des données historiques et des données de vol en temps réel, et
fournir des données d'aide pour l'interprétation dans l'opération d'aide pour la décision de commande de vol ; et
un sous-module de prévision d'états de vol, configuré pour pré-estimer et prévoir la courbe de trajectoire, avec des données de vol en orbite en temps réel en tant que condition initiale, pour obtenir un résultat de prévision pour un état de la commande de vol avant un événement clé et fournir une aide à la décision pour une détermination à l'avance dans une mission de commande de vol.

7. Système selon la revendication 1, dans lequel le module (105) d'analyse intelligente dans une commande de vol est en outre configuré pour :
fournir une interface standardisée, via laquelle un plug-in externe échange des données avec le module (105) d'analyse intelligente dans une commande de vol.

8. Système selon la revendication 1, dans lequel le module (106) d'aide à la décision dans une commande de vol comprend :
un sous-module de traitement de décision automatique en procédure de commande de vol normale, configuré pour :
extraire, sur la base de la mission de vol, des données nécessaires dans la mission de vol à partir du module (103) de fusion et de traitement de données multi-sources ;
générer des données d'injection de liaison montante sur la base des données extraites nécessaires dans la mission de vol ;
déterminer les données nécessaires dans la mission de vol et les données d'injection de liaison montante en tant que données d'entrée, et déclencher le module (102) de simulation et de vérification dans la commande de vol pour simuler et vérifier les données d'injection de liaison montante, pour obtenir un résultat de simulation et de vérification ;
télécharger les données d'injection de liaison montante qui sont vérifiées vers l'engin spatial, via le module (103) de fusion et de traitement de données multi-sources qui acquièrent le résultat de simulation et de vérification émis par le module (102) de simulation et de vérification dans une commande de vol ;
acquérir un résultat de fonctionnement de l'engin spatial, qui est sur la base des données d'injection de liaison montante qui sont vérifiées ;
vérifier à nouveau, sur la base du résultat de fonctionnement, les données d'injection de liaison montante qui sont vérifiées ;
dans lequel le résultat de simulation et de vérification qui est émis par le module (102) de simulation et de vérification dans une commande de vol et acquis par le module (103) de fusion et de traitement de données multi-sources comprend : les données d'injection de liaison montante qui sont vérifiées à travers la simulation et la vérification ; et
dans lequel les données nécessaires dans la mission de vol comprennent des informations d'attitude d'engin spatial, des informations d'orbite et des informations de santé d'un état de fonctionnement ;
un sous-module de traitement de pré-avertissement de sécurité, configuré pour :
acquérir des informations d'état de sécurité de l'engin spatial, des informations de couloir de sécurité d'une orbite et des informations d'état de santé d'un actionneur de capteur, à partir du module (103) de fusion et de traitement de données multi-sources ;
comparer les informations d'état de sécurité de l'engin spatial, les informations de couloir de sécurité de l'orbite et les informations d'état de santé de l'actionneur de capteur avec des seuils, respectivement ; et
exécuter un pré-avertissement de sécurité sur la base d'un résultat de la comparaison ; et
un sous-module de traitement d'urgence de panne, configuré pour :
acquérir des informations d'une panne d'urgence soudaine pendant la mission de vol, à partir du module (103) de fusion et de traitement de données multi-sources ;
sélectionner un plan de secours pour la panne d'urgence soudaine, dans lequel le plan de secours correspond aux informations de la panne d'urgence soudaine ;
déterminer si la panne d'urgence soudaine est éliminée après l'exécution du plan de secours de panne d'urgence soudaine ; et
déclencher le sous-module de traitement de pré-avertissement de sécurité, dans le cas où la panne d'urgence soudaine est éliminée.

9. Système selon la revendication 2, dans lequel le module (107) d'affichage de courbes et de traitement d'opérations d'interface comprend :
un sous-module d'affichage de courbes, configuré pour actualiser, périodiquement ou pour une fois, les données hétérogènes multi-sources correspondant à l'opération d'aide à la décision de commande de vol sur l'interface, pour permettre aux données hétérogènes multi-sources d'être réglables le long d'un axe horizontal et d'un axe vertical, facilitant la comparaison et l'analyse de données et fournissant une scène d'affichage visuel pour le traitement de données ; et
un sous-module pour des opérations d'interface, configuré pour fournir une option de fonction pour gérer un fichier de configuration, une option de fonction pour stocker des données, une option de fonction pour extraire des données, une option de fonction pour afficher une courbe, une option de fonction pour un calcul de données et une option de fonction pour une liaison à une bibliothèque de traitement dynamique.
